# EUROPEAN PATENT APPLICATION

(11) **EP 1 134 810 A2**
(43) Date of publication of application: **19.09.2001**
(21) Application number: 00127979.3
(22) Date of filing: 20.12.2000
(51) Int. Cl.: H01L 29/778

(54) **Field effect transistor**

(30) Priority: 20.12.1999 JP 36105799
(71) Applicant: NEC CORPORATION, Tokyo (JP)
(72) Inventor: Bito, Yasunori, Minato-ku, Tokyo (JP); Ando, Yuji, Minato-ku, Tokyo (JP)
(74) Representative: Glawe, Delfs, Moll & Partner

(57) **Abstract**

There is disclosed a field effect transistor of an epitaxial structure comprising an undoped Al_{0.5}Ga_{0.5}As barrier layer 106 having a film thickness of 3nm to 10nm, formed between an undoped In_{0.2}Ga_{0.8}As channel layer 105 and a Si-doped Al_{0.2}Ga_{0.8}As upper electron supplying layer 107, so that a potential barrier is formed just above a channel. In a forward direction gate biasing condition, the height of a Schottky barrier formed by a contact with a gate electrode becomes low, but the height of the potential barrier formed just above the channel does not substantially change so that the potential barrier effectively functions as a barrier against electrons within the channel. As a result, when a forward direction gate voltage is large, the gate current is effectively reduced, so that a gate forward direction rising voltage can be elevated. Thus, a large maximum drain current or a low on-resistance can be obtained. Furthermore, a gate leak current is reduced in the forward direction gate biasing condition.

## Description

### Background of the invention

The present invention relates to a field effect transistor (abbreviated to "FET" in this specification), and more specifically to a heterojunction FET having a large gate forward direction rising voltage.

A GaAs FET is used as a high power output element in a transmitter of a mobile communication terminal, since the GaAs FET has a low on-resistance and can operate at a low voltage with a high efficiency. In particular, recently, a high power GaAs FET is demanded not only to be an enhancement type having a positive threshold voltage but also to have a feature that a leak drain current at a gate voltage of 0V is perfectly cut off. If this demand is satisfied, it becomes possible to omit a DC/DC converter for generating a negative voltage for a gate bias and a drain bias switch for cutting off the drain current, which were required in the prior art, with the result that a mobile terminal can further be reduced in size and in weight.

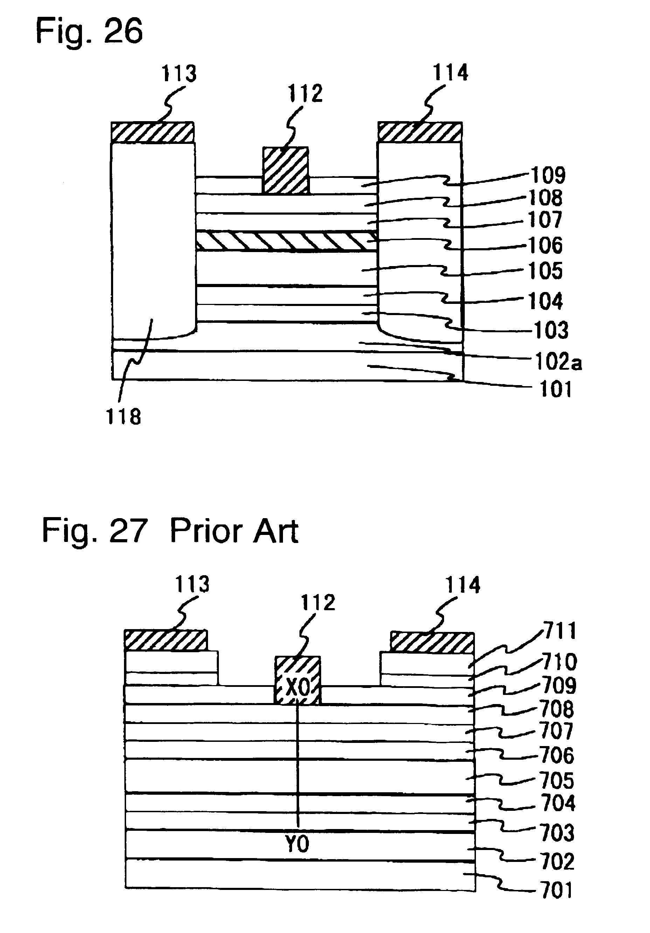

As regards the FET having the above mentioned feature, an enhancement type FET having a threshold voltage of not less than for example 0.3V will be exemplified. Referring to Fig. 27, there is shown a diagrammatic sectional view of an example of an enhancement type heterojunction FET having a threshold voltage of 0.3V.

As shown in Fig. 27, the enhancement type heterojunction GaAs FET includes an undoped Al_{0.2}Ga_{0.8}As gate contact layer 708 having a low aluminum composition ratio in order to avoid a problem of a surface oxidation, and an Si-doped Al_{0.2}Ga_{0.8}As electron supplying layer 707, an undoped Al_{0.2}Ga_{0.8}As spacer layer 706 and an undoped In_{0.2}Ga_{0.8}As channel layer 705, which have a low aluminum composition ratio in order to avoid a problem of a DX center.

In brief, the reference number 701 designates a semi-insulative GaAs substrate, and the reference number 702 indicates an undoped Al_{0.2}Ga_{0.8}As buffer layer. The reference number 703 shows a Si-doped A1_{0.2}Ga_{0.8}As electron supplying layer, and the reference number 704 denotes an undoped Al_{0.2}Ga_{0.8}As spacer layer. The reference number 709 designates an undoped GaAs gate buried layer, and the reference number 710 indicates an Si-doped Al_{0.2}Ga_{0.8}As wide recess stopper layer. The reference number 711 shows an Si-doped GaAs cap layer, and the reference number 712 denotes a gate electrode. The reference number 713 designates a source electrode, and the reference number 714 designates a drain electrode.

A gate forward direction voltage is 0.7V. As a result, a switching width of a gate voltage becomes small. For example, a depletion type FET having a threshold of -1V can have a gate voltage switching width until 0.7 - (-1) = 1. 7 (V), however, an enhancement type FET having a threshold of +0.3V can have only a gate voltage switching width as small as 0.7 - (+0.3) = 0.4 (V). Therefore, in a power operation, a gate is turned on in a forward direction, with the result that a large gate current flows unconventionally.

Under this circumstance, Japanese Patent Application Pre-examination Publication No. JP-A-09-246525 proposes an enhancement type FET having a gate forward direction voltage elevated by using a barrier layer formed of an AlGaAs semiconductor layer having a high aluminum composition ratio. Referring to Fig. 28, there is shown a diagrammatic sectional view of an example disclosed in JP-A-09-246525, in which a gate forward direction voltage is elevated to 1.5V by using a barrier layer 804 formed of an Al_{0.8}Ga_{0.2}As semiconductor layer (undoped AlGaAs lower Schottky contact layer) having a thickness of 20nm.

In brief, the reference number 801 designates a scmi-insulative GaAs substrate, and the reference number 802 indicates a buffer layer. The reference number 803 shows a Si-doped InGaAs channel layer, and the reference number 805 denotes an undoped Al_{0.3}Ga_{0.7}As upper Schottky contact layer. The reference number 806 designates an Si-doped GaAs cap layer, and the reference number 807 indicates a gate electrode. The reference number 808 shows a source electrode, and the reference number 809 denotes a drain electrode. The reference number designates a silicon implanted region.

However, in this prior art example, since a thick barrier layer 804 exists between the channel layer 803 and each of the source electrode 808 and the drain electrode 809, there is another problem in which it is necessary to reduce a contact resistance by use of an Si-ion implantation process and an activating annealing process. In addition, since an n-type impurity is added into the channel layer 803, the mobility in the channel layer is low, with the result that it is difficult to realize a low on-resistance.

Furthermore, 1997 IEEE MTT-S Digest Vol. 3, Pages 1399-1402 (1997) proposes an example of the FET having a barrier layer formed of an AlGaAs semiconductor layer similarly having a high aluminum composition ratio, and reports that the gate forward direction voltage of the FET is elevated to 1.6V.

However, this second example includes a thick barrier layer exists between a channel layer and each of a source electrode and a drain electrode, so that a similar problem is encountered in which it is necessary to reduce a contact resistance by use of an Si-ion implantation process. In addition, this second example has a single doped epitaxial structure in which an electron supplying layer is provided only under an undoped channel layer. Since no impurity is doped in the channel layer, the mobility in the channel layer is high. However, because of the single doped structure in which the electron supplying layer is provided only under the channel layer, a sheet carrier concentration in the channel is low, with the result that a drain current is as small as 180 - 200 mA/mm

Furthermore, in the case that an AlGaAs barrier layer having a high aluminum composition ratio and a thickness of not less than 20nm is provided on a channel layer, as in the above mentioned prior art examples, there is still another problem in which a double doped structure cannot be adopted in order to elevate the sheet carrier concentration in the channel layer. The reason for this is that: In an AlGaAs layer having an aluminum composition ratio of greater than 0.3, a deep energy level (DX center) is formed, so that even if an n-type impurity is added, the n-type impurity is not activated with the result that carriers are not accumulated in the channel layer. Therefore, this layer cannot be used as an electron supplying layer. In this connection, even if an electron supplying layer is provided on the AlGaAs barrier layer having the high aluminum composition ratio, since the electron supplying layer is separated from the channel layer by a distance of not less than 20nm, the sheet carrier concentration in the channel layer remains small.

As another example, Japanese Patent Application Pre-examination Publication No. JP-A-59-028383 proposes a heterojunction FET structure in which a potential barrier is provided just above the channel to prevent high energy electrons in the channel layer from being scattered into an electron supplying layer. Since this proposed structure has an AlGaAs layer having a high aluminum composition ratio provided on the channel layer, it is effective in elevating the gate forward direction voltage. However, as seen from a first embodiment (shown by (c) in a single drawing of JP-A-59-028383), since a thick barrier layer is formed of an AlAs layer having a thickness of 40Å and an Al_{0.55}Ga_{0.45}As layer having a thickness of 500Å, the contact resistance is large and a maximum drain current is small.

### Brief summary of the invention

Accordingly, it is an object of the present invention to provide a field effect transistor which has overcome the above mentioned problems of the prior art.

Another object of the present invention is to provide a field effect transistor which has a large maximum drain current or a low on-resistance and which can be fabricated without increasing a complicated fabricating step exemplified by an ion implantation.

Still another object of the present invention is to provide a field effect transistor of an epitaxial structure which has a reduced gate leak current in a gate forward direction biasing condition, so that a gate forward direction rising voltage can be elevated.

According to a first aspect of the present invention, there is provided a field effect transistor which includes at least a first semiconductor layer in which carriers flows, and a second semiconductor layer formed on the first semiconductor layer, the second semiconductor layer having an electron affinity smaller that of the first semiconductor layer, and the second semiconductor layer being doped with an n-type impurity, wherein a semiconductor barrier layer is inserted between the first semiconductor layer and the second semiconductor layer, the semiconductor barrier layer having a positive electron energy at a conduction band bottom of a Γ valley, in comparison with an electron energy at a conduction band bottom of a Γ valley in the second semiconductor layer, the semiconductor barrier layer having a film thickness of not less than 3nm but not greater than 10nm.

When the semiconductor barrier layer is in lattice mismatching with a semiconductor substrate on which semiconductor layers are grown, and if a maximum film thickness of the semiconductor barrier layer in which no dislocation occurs, is less than 10nm, the semiconductor barrier layer has the film thickness of not less than 3nm but not greater than the maximum film thickness in which no dislocation occurs.

In an embodiment of the field effect transistor in accordance with the first aspect of the present invention, the first semiconductor layer is formed of a material selected from the group consisting of InGaAs and GaAs, the second semiconductor layer is formed of a material selected from the group consisting of Al_{X₁}Ga_{1-X₁}As where 0≤X₁≤0.3, and InGaP, and the semiconductor barrier layer is formed of Al_{X₂}Ga_{1-X₂}As where 0.4≤X₂≤1.

In another embodiment of the field effect transistor in accordance with the first aspect of the present invention, the first semiconductor layer is formed of a material selected from the group consisting of InGaAs and GaAs, the second semiconductor layer is formed of a material selected from the group consisting of Al_{X₁}Ga_{1-X₁}As where 0≤X₁≤0.3, and InGaP, and the semiconductor barrier layer is formed of (Al_{X₂}Ga_{1-X₂})_{Y}In_{1-Y}P where 0.2≤X₂≤1, and 0.4<Y<0.6.

In still another embodiment of the field effect transistor in accordance with the first aspect of the present invention, the first semiconductor layer is formed of a material selected from the group consisting of InGaAs and GaAs, the second semiconductor layer is formed of a material selected from the group consisting of Al_{X₁}Ga_{1-X₁}As where 0≤X₁≤0.3, and InGaP, and the semiconductor barrier layer is formed of (Al_{X₂}Ga_{1-X₂})_{Y}In_{1-Y}P where 0≤X₂≤1, and 0.6≤Y≤1.

In a further embodiment of the field effect transistor in accordance with the first aspect of the present invention, the first semiconductor layer is formed of InGaAs, the second semiconductor layer is formed of a material selected from the group consisting of AlInAs and AlGaInAs, and the semiconductor barrier layer is formed of (Al_{X}Ga_{1-X})_{Y}In_{1-Y}As where 0.4≤X≤1, and 0.6≤Y≤1.

In still another embodiment of the field effect transistor in accordance with the first aspect of the present invention, the semiconductor barrier layer having an undoped layer portion near to a channel layer and an n-type impurity doped layer portion at a gate electrode side.

In a further embodiment of the field effect transistor in accordance with the first aspect of the present invention, the semiconductor barrier layer is formed of a material selected from the group consisting of (Al_{X}Ga_{1-X})_{Y}In_{1-Y}P where 0.2≤X≤0.3, and 0.4<Y≤1.0 and (Al_{X}Ga₁₋ _{X})_{Y}In_{1-Y}As where 0.4≤X≤1, and 0.6≤Y<0.7, and the semiconductor barrier layer having an undoped layer portion at a side of the first semiconductor layer and an n-type impurity doped layer portion at a gate electrode side.

The field effect transistor in accordance with the first aspect of the present invention can further includes an n-type impurity doped semiconductor layer formed under the first semiconductor layer and having an electron affinity smaller that of the first semiconductor layer.

According to a second aspect of the present invention, there is provided a field effect transistor which includes at least a first semiconductor layer in which carriers flows, and a second semiconductor layer formed on the first semiconductor layer, the second semiconductor layer having an electron affinity smaller that of the first semiconductor layer, and the second semiconductor layer being doped with an n-type impurity, wherein a first semiconductor barrier layer is inserted between the first semiconductor layer and the second semiconductor layer, and a second semiconductor barrier layer is inserted between the second semiconductor layer and a gate electrode, each of the first and second semiconductor barrier layers having a positive electron energy at a conduction band bottom of a Γ valley, in comparison with an electron energy at a conduction band bottom of a Γ valley in the second semiconductor layer, each of the first and second semiconductor barrier layers having a film thickness of not less than 3nm but not greater than 10nm.

When at least one of the first and second semiconductor barrier layers is in lattice mismatching with a semiconductor substrate on which semiconductor layers are grown, if a maximum film thickness of the at least one of the first and second semiconductor barrier layers in which no dislocation occurs, is less than 10nm, the at least one of the first and second semiconductor barrier layers has the film thickness of not less than 3nm but not greater than the maximum film thickness in which no dislocation occurs.

In an embodiment of the field effect transistor in accordance with the second aspect of the present invention, the first semiconductor layer is formed of a material selected from the group consisting of InGaAs and GaAs, the second semiconductor layer is formed of a material selected from the group consisting of Al_{X₁}Ga_{1-X₁}As where 0≤X₁≤0.3, and InGaP. The first semiconductor barrier layer is formed of a material selected from the group consisting of Al_{X₂}Ga_{1-X₂}AS where 0.4<X₂≤1, (Al_{X₃}Ga_{1-X₃})_{Y1}In_{1-Y1}P where 0.2≤X₃≤1, and 0.4<Y₁<0.6, and (Al_{X₄}Ga_{1-X₄})_{Y2}In_{1-Y2}P where 0≤X₄≤1, and 0.6≤Y₂≤1, and the second semiconductor barrier layer is formed of a material selected from the group consisting of Al_{X₅}Ga_{1-X₅}As where 0.4<X₅≤1, (Al_{X₆}Ga_{1-X₆})_{Y3}In₁₋ _{Y3}P where 0.2≤X₆≤1, and 0.4<Y₃<0.6, and (Al_{X₇}Ga_{1-X₇})_{Y4}In_{1-Y4}P where 0≤X₇≤1, and 0.6<Y₄≤1.

In another embodiment of the field effect transistor in accordance with the second aspect of the present invention, the first semiconductor layer is formed of InGaAs, the second semiconductor layer is formed of a material selected from the group consisting of AlInAs and AlGaInAs. The first semiconductor barrier layer is formed of (Al_{X₁}Ga_{1-X₁})_{Y}In₁₋ _{Y1}As where 0.4≤X₁≤1, and 0.6≤Y₁≤1, and the second semiconductor barrier layer is formed of (Al_{X₂}Ga_{1-X₂})_{Y₂}In_{1-Y2}As where 0.4≤X₂≤1, and 0.6≤Y₂≤1.

In still another embodiment of the field effect transistor in accordance with the second aspect of the present invention, a portion or all of the first semiconductor barrier layer near to a channel layer is doped with an n-type impurity.

In a further embodiment of the field effect transistor in accordance with the second aspect of the present invention, the first semiconductor barrier layer near to the first semiconductor layer is formed of a material selected from the group consisting of (Al_{X}Ga_{1-X})_{Y}In_{1-Y}P where 0.2≤X≤0.3, and 0.4<Y≤1.0 and (Al_{X}Ga_{1-X})_{Y}In_{1-Y}As where 0.4≤X≤1, and 0.6≤Y<0.7, and a portion or all of the first semiconductor barrier layer is doped with an n-type impurity.

The field effect transistor in accordance with the second aspect of the present invention can further include an n-type impurity doped semiconductor layer formed under the first semiconductor layer and having an electron affinity smaller that of the first semiconductor layer.

As seen from the above, according to the present invention, a potential barrier formed by a semiconductor barrier layer inserted between a channel layer and an upper electron supplying layer, effectively functions as a barrier in a forward direction gate biasing condition, so that a gate leak current is reduced in the forward direction gate biasing condition and a gate forward direction rising voltage can be elevated.

Furthermore, according to the present invention, not only a semiconductor barrier layer inserted between a channel layer and an upper electron supplying layer, but also a semiconductor barrier layer inserted between the upper electron supplying layer and a gate electrode. With this arrangement, in a low biasing condition, a barrier near to the gate electrode reduce the gate current, and in a high biasing condition, a barrier near to the channel reduces the gate current, so that a gate forward direction rising voltage can be elevated.

Moreover, according to the present invention, the film thickness of the semiconductor barrier layer is not less than 3nm but not greater than 10nm, or alternatively, not less than 3nm but not greater than the maximum film thickness in which no dislocation occurs. With this arrangement, a tunnel current passing through the potential is sufficiently large. Therefore, a contact resistance between the channel layer and each of a source electrode and a drain electrode is not increased, and an ohmic characteristics is not deteriorated. As a result, the process for implanting ions into an ohmic region, and the succeeding annealing process, which were performed in the prior art in the case having a thick barrier layer, are no longer required, and therefore, a fabricating process can be simplified. Furthermore, since a distance between the upper electron supplying layer and the channel layer is short, a large number of electrons arc accumulated in the channel layer, so that a maximum drain current can be increased.

In addition, according to the present invention, a channel layer side portion of the semiconductor barrier layer is not doped with impurity, but a gate electrode side portion of the semiconductor barrier layer is doped with an n-type impurity, so that a portion of the semiconductor barrier layer functions as an electron supplying layer. In this arrangement, since the distance between the upper electron supplying layer and the channel layer becomes further short, a very large number of electrons are accumulated in the channel layer, so that a maximum drain current can be further increased.

Furthermore, according to the present invention, in the field effect transistor having the two semiconductor barrier layers, a portion or all of the semiconductor barrier layer near to a channel layer is doped with an n-type impurity. In this arrangement, since the distance between the upper electron supplying layer and the channel layer becomes further short, a very large number of clcctrons are accumulated in the channel layer, so that a maximum drain current can be further increased.

The above and other objects, features and advantages of the present invention will be apparent from the following description of preferred embodiments of the invention with reference to the accompanying drawings.

### Brief description of the drawings

Fig. 1 is a diagrammatic sectional view of a heterojunction FET which is a first embodiment of the FET in accordance with the present invention;
Fig. 2 is a potential energy diagram along the line X1-Y1 in Fig. 1;
Fig. 3 is a graph illustrating a gate forward direction current characteristics in the heterojunction FET which is the first embodiment of the FET in accordance with the present invention and in a heterojunction FET having the prior art structure;
Figs. 4A and 4B are graphs illustrating a barrier layer film thickness dependency of a sheet carrier concentration in the channel, an on-resistance, and a gate forward direction rising voltage;
Figs. 5A to 5F are diagrammatic sectional views illustrating a process for fabricating the heterojunction FET shown in Fig. 1;
Fig. 6 is a diagrammatic sectional view of a modification of the first embodiment of the FET in accordance with the present invention;
Fig. 7 is a potential energy diagram along the line X2-Y2 in Fig. 6;
Figs. 8A to 8F are diagrammatic sectional views illustrating a process for fabricating the heterojunction FET shown in Fig. 6;
Fig. 9 is a diagrammatic sectional view of another modification of the first embodiment of the FET in accordance with the present invention;
Fig. 10 is a diagrammatic sectional view of still another modification of the first embodiment of the FET in accordance with the present invention;
Fig. 11 is a diagrammatic sectional view of a further modification of the first embodiment of the FET in accordance with the present invention;
Fig. 12 is a diagrammatic sectional view of a still further modification of the first embodiment of the FET in accordance with the present invention;
Fig. 13 is a graph illustrating a dependency to a composition ratio Y of a critical film thickness of an (Al_{0.5}Ga_{0.5})_{Y}In_{1-Y}P film grown on a GaAs substrate;
Fig. 14 is a diagrammatic sectional view of a further modification of the first embodiment of the FET in accordance with the present invention;
Fig. 15 is a graph illustrating a dependency to a composition ratio X of a critical film thickness of an Al_{X}In_{1-X}As film grown on an InP substrate;
Fig. 16 is a diagrammatic sectional view of a heterojunction FET which is a second embodiment of the FET in accordance with the present invention;
Fig. 17 is a potential energy diagram along the line X3-Y3 in Fig. 16;
Fig. 18 is a graph illustrating a gate forward direction current characteristics in the hcterojunction FET which is the second embodiment of the FET in accordance with the present invention and in a heterojunction FET having the prior art structure;
Fig. 19 is a diagrammatic sectional view of a modification of the second embodiment of the FET in accordance with the present invention;
Fig. 20 is a diagrammatic sectional view of another modification of the second embodiment of the FET in accordance with the present invention;
Fig. 21 is a diagrammatic sectional view of still another modification of the second embodiment of the FET in accordance with the present invention;
Fig. 22 is a diagrammatic sectional view of a further modification of the second embodiment of the FET in accordance with the present invention;
Fig. 23 is a diagrammatic sectional view of a still further modification of the second embodiment of the FET in accordance with the present invention;
Fig. 24 is a diagrammatic sectional view of a further modification of the first embodiment of the FET in accordance with the present invention;
Fig. 25 is a diagrammatic sectional view of a further modification of the second embodiment of the FET in accordance with the present invention;
Fig. 26 is a diagrammatic sectional view of a still further modification of the first embodiment of the FET in accordance with the present invention;
Fig. 27 is a diagrammatic sectional view of an example of the prior art heterojunction FET; and

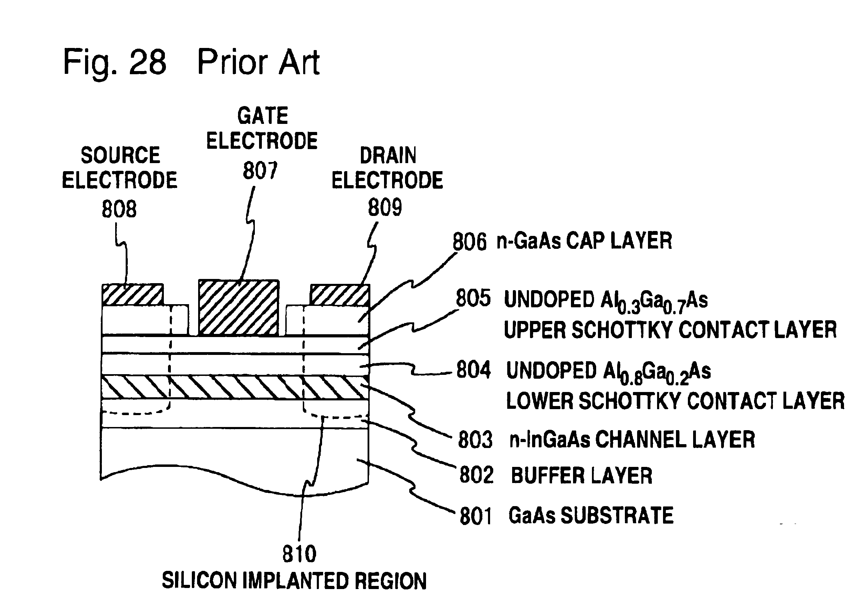

Fig. 28 is a diagrammatic sectional view of another example of the prior art heterojunction FET having an AlGaAs barrier layer having a large aluminum composition ratio.

### Detailed description of the invention

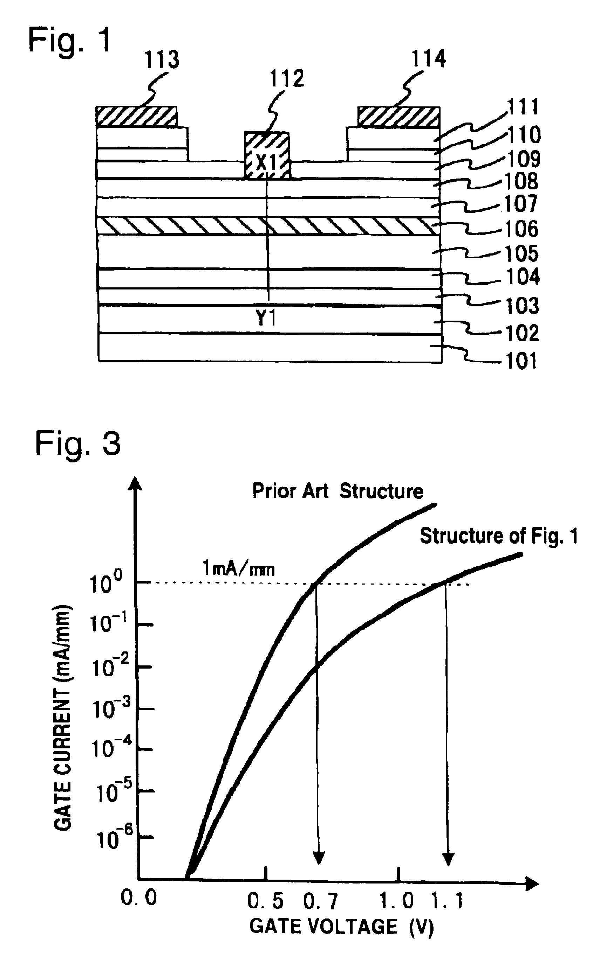

Referring to Fig. 1, there is shown a diagrammatic sectional view of a heterojunction FET which is a first embodiment of the FET in accordance with the present invention. In Fig. 1, the reference number 101 designates a semi-insulative GaAs substrate, and the reference number 102 indicates an undoped Al_{0.2}Ga_{0.8}As buffer layer. The reference number 103 shows a Si-doped Al_{0.2}Ga_{0.8}As lower electron supplying layer, and the reference number 104 denotes an undoped Al_{0.2}Ga_{0.8}As spacer layer. The reference number 105 designates an undoped In_{0.2}Ga_{0.8}As channel layer, and the reference number 106 indicates an undoped Al_{0.5}Ga_{0.5}As barrier layer. The reference number 107 shows an Si-doped Al_{0.2}Ga_{0.8}As upper electron supplying layer, and the reference number 108 denotes an undoped Al_{0.2}Ga_{0.8}As gate contact layer. The reference number 109 designates an undoped GaAs gate buried layer, and the reference number 110 indicates an Si-doped Al_{0.2}Ga_{0.8}As wide recess stopper layer. The reference number 111 shows an Si-doped GaAs cap layer, and the reference number 112 denotes a gate electrode. The reference number 113 designates a source electrode, and the reference number 114 designates a drain electrode.

The field effect transistor in this embodiment is characterized in that the undoped Al_{0.5}Ga_{0.5}As barrier layer 106 having a film thickness of 5nm is formed between the undoped In_{0.2}Ga_{0.8}As channel layer 105 and the Si-doped Al_{0.2}Ga_{0.8}As upper electron supplying layer 107. The undoped Al_{0.5}Ga_{0.5}As barrier layer 106 forms a barrier layer which is higher than that in the prior art using the undoped Al_{0.2}Ga_{0.8}As spacer layer 706 shown in Fig. 27, by 0.2eV in the r valley

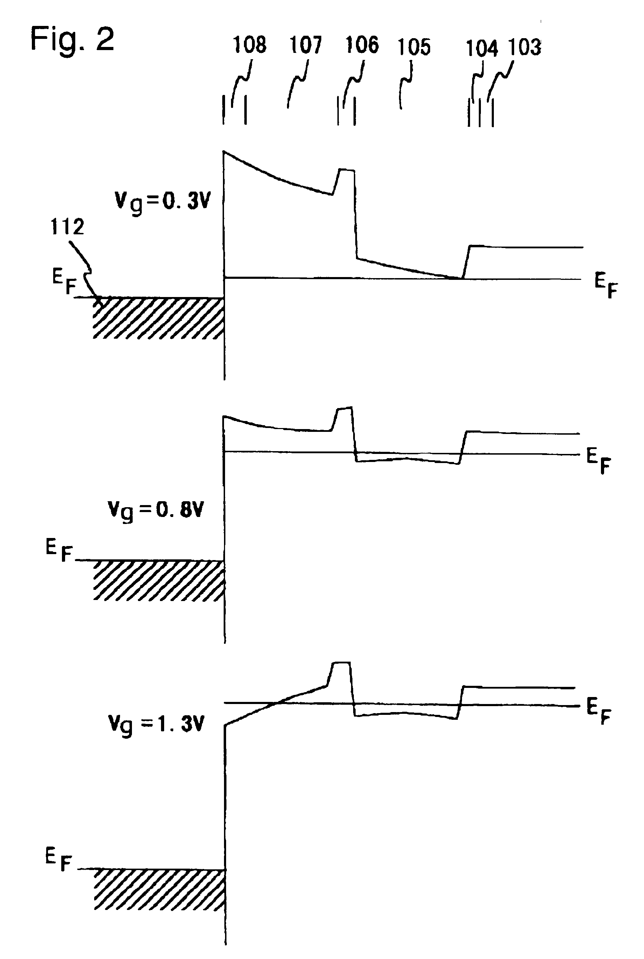

Fig. 2 illustrates a conduction band profile in the X1-Y1 direction in Fig. 1 when various voltages "Vg" of +0.3V, +0.8V and +1.3V are applied to the gate electrode 112. With the structure proposed by the present invention, a potential barrier is formed just above the channel. If a gate bias voltage "Vg" is gradually increased in a forward direction, the height of the Schottky barrier formed by a contact with the gate electrode gradually becomes low, but the height of the potential barrier formed just above the channel does not substantially change, so that the potential barrier formed just above the channel effectively functions as a barrier against electrons within the channel. In other words, in the structure having the barrier layer formed just above the channel layer, when the gate voltage in the forward direction is large, it is possible to effectively reduce the gate current so that a gate forward direction rising voltage can be elevated.

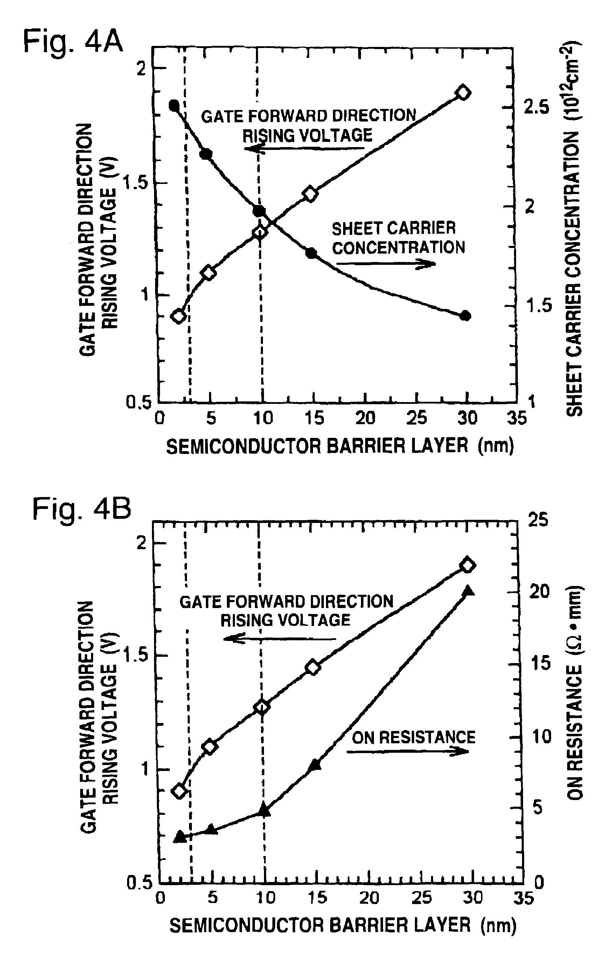

Fig. 3 illustrates a gate voltage dependency of the gate forward direction current. As seen from Fig. 3, if the gate voltage is less than 0.3V, the structure of Fig. 1 and the prior art structure have a gate current of substantially the same magnitude. However, if the gate voltage is not less than 0.3V, the barrier layer formed just above the channel layer starts to exert its function, so that the gate current is suppressed in the structure of Fig. 1. As a result, the gate forward direction rising voltage, which is defined to be a gate voltage when a gate current is at 1mA/mm, can be elevated.

Figs. 4A and 4B illustrates a dependency to the film thickness of the barrier layer 106, of a sheet carrier concentration accumulated in the channel layer, an on-resistance, and the gate forward direction rising voltage. The larger the film thickness of the barrier layer 106 is, the larger the gate forward direction rising voltage becomes. However, in order to obtain the gate forward direction rising voltage of 1.0V, it is sufficient if the barrier layer 106 has the film thickness of 3nm. On the other hand, if the film thickness of the barrier layer 106 becomes large, the distance between the Al_{0.2}Ga_{0.8}As upper electron supplying layer 107 and the undoped In_{0.2}Ga_{0.8}As channel layer 105 becomes large, so that the carrier concentration accumulated in the channel layer lowers. In addition, if the film thickness of the barrier layer 106 becomes large, the contact resistance between the channel layer and each of the source electrode and the drain electrode becomes large, so that the on-resistance in the FET becomes large. In particular, if the film thickness of the barrier layer 106 exceeds 10nm, the on-resistance abruptly increases. Therefore, in order to avoid an increase of a parasite resistance component (on-resistance), it is sufficient if the film thickness of the barrier layer 106 is not greater than 10nm.

From Fig. 3, the heterojunction FET of the first embodiment as mentioned above has a threshold voltage of +0.3V and the gate forward direction rising voltage of +1.1V. This gate forward direction rising voltage becomes higher than that of the prior art heterojunction FET by 0.4V. In addition, since the heterojunction FET of the first embodiment has a double doped structure in which the electron supplying layers are formed above and under the channel layer, respectively, a maximum drain current is as large as 350mA/mm.

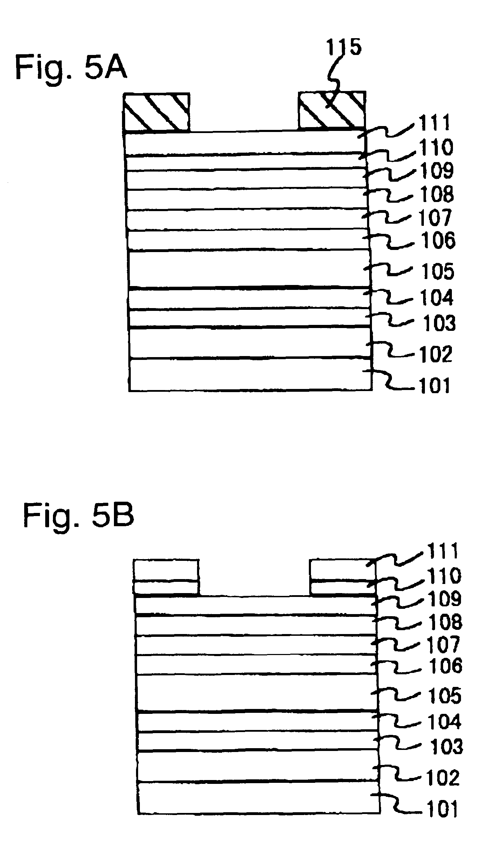

Now, a process for fabricating the heterojunction FET shown in Fig. 1 will be described with reference to Figs. 5A to 5F, which are diagrammatic sectional views illustrating a process for fabricating the heterojunction FET shown in Fig. 1.

As shown in Fig. 5A, on the semi-insulative GaAs substrate 101, by means of a molecular beam epitaxy or an organometallic vapor phase epitaxy there are epitaxially grown in the named order an undoped Al_{0.2}Ga_{0.8}As buffer layer 102 having a film thickness of 500nm, an Al_{0.2}Ga_{0.8}As electron supplying layer 103 doped with Si at an impurity concentration of 4×10¹⁸cm⁻³ and having a film thickness of 4nm, an undoped Al_{0.2}Ga_{0.8}As spacer layer 104 having a film thickness of 2nm, an undoped In_{0.2}Ga_{0.8}As channel layer 105 having a film thickness of 15nm, an undoped Al_{0.5}Ga_{0.5}As barrier layer 106 having a film thickness of 5nm, an Al_{0.2}Ga_{0.8}As electron supplying layer 107 doped with Si at an impurity concentration of 4×10¹⁸cm⁻³ and having a film thickness of 9nm, an undoped Al_{0.2}Ga_{0.8}As gate contact layer 108 having a film thickness of 5nm, an undoped GaAs gate buried layer 109 having a film thickness of 15nm, an Al_{0.2}Ga_{0.8}As wide recess stopper layer 110 having a film thickness of 5nm, and a GaAs cap layer 111 doped with Si at an impurity concentration of 4×10¹⁸cm⁻³ and having a film thickness of 100nm.

Furthermore, as shown in Fig. 5A, a patterned mask 115 having an opening corresponding to a wide recess is formed on the GaAs cap layer 111 of the substrate thus formed. The GaAs cap layer 111 is selectively etched by using the patterned mask 115 as an etching mask and by using the Al_{0.2}Ga_{0.8}As wide recess stopper layer 110 as an etching stopper layer. In addition, the Al_{0.2}Ga_{0.8}As wide recess stopper layer 110 is selectively etched by using the patterned mask 115 as an etching mask.

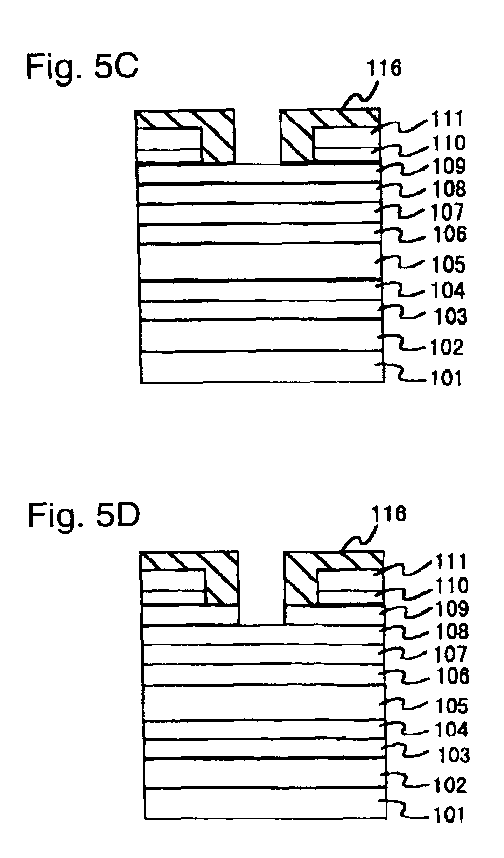

After the mask 115 is removed as shown in Fig. 5B, a new mask 116 having an opening corresponding to a gate recess is formed as shown in Fig. 5C. The GaAs gate buried layer 109 is selectively etched by using the patterned mask 116 as an etching mask and by using the Al_{0.2}Ga_{0.8}As gate contact layer 108 as an etching stopper layer, as shown in Fig. 5D.

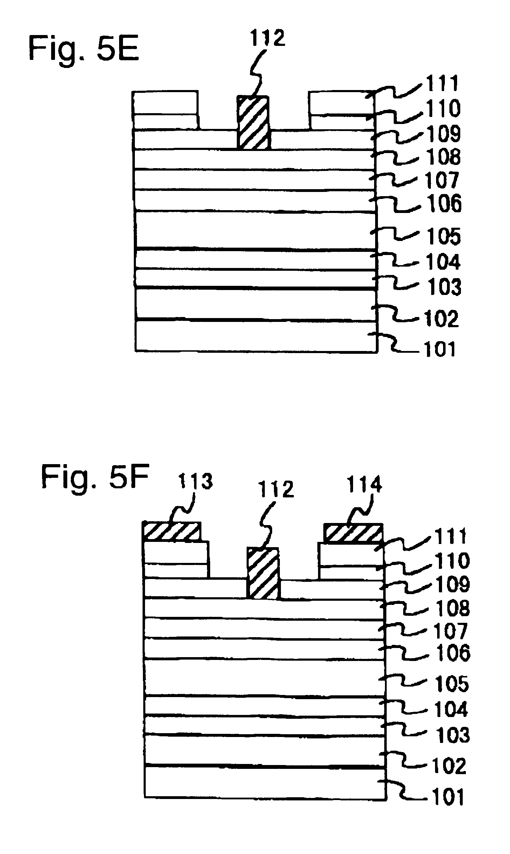

Thus, a WSi gate electrode 112 is formed on an exposed surface of the Al_{0.2}Ga_{0.8}As gate contact layer 108, and the mask 116 is removed as shown in Fig. 5E. Thereafter, a not shown mask is formed for formation of the source electrode and the drain electrode, and an AuGe film is vaporized, and a lift-off process is carried out, and then, a heat treatment is performed for alloying, so that the source electrode 113 and the drain electrode 114 are formed as shown in Fig. 5F.

In the above mentioned embodiment, the barrier layer is constituted of the AlGaAs layer having the aluminum composition ratio of 0.5 and the film thickness of 5nm. However, as seen from Figs. 4A and 4B, if the film thickness is not less than 3nm but not greater than lOnm and if the aluminum composition ratio is not less than 0.4, it is possible to elevate the gate forward direction rising voltage without deteriorating the maximum drain current and the on-resistance.

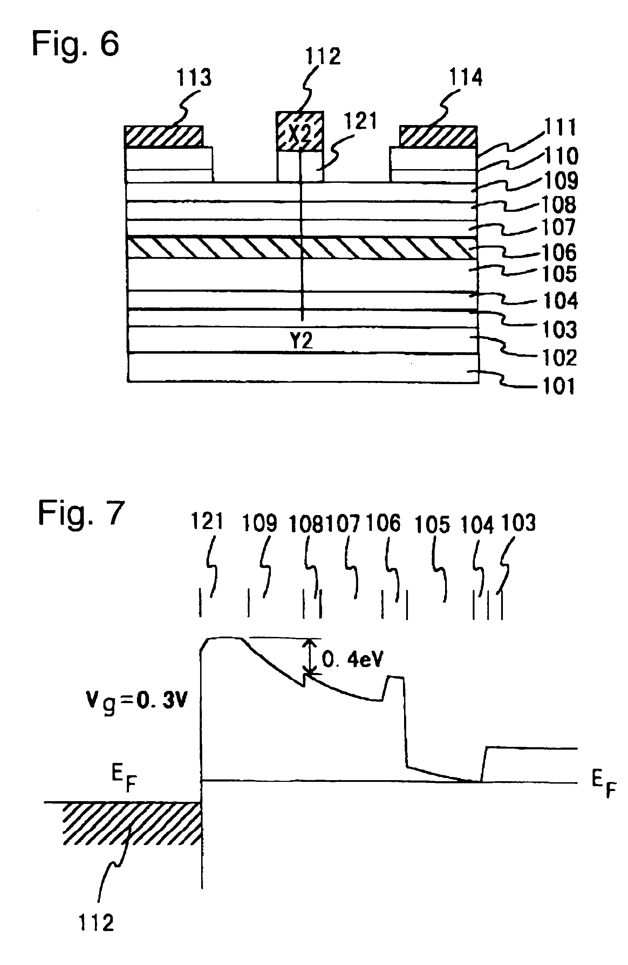

Fig. 6 is a diagrammatic sectional view of a modification of the first embodiment of the FET in accordance with the present invention. The heterojunction FET shown in Fig. 6 is characterized in that no gate recess is formed in the undoped GaAs gate buried layer 109 having the film thickness of 15nm shown in Fig. 1, and a GaAs layer 121 doped with a p-type impurity at an impurity concentration of 4×10¹⁹cm⁻³ and having a film thickness of 50nm is formed on the undoped GaAs gate buried layer 109, and the WSi gate electrode 112 is formed on the GaAs layer 121

Fig. 7 is a potential energy diagram along the line X2-Y2 in Fig. 6 when the voltage of +0.3V is applied to the WSi gate electrode 112. Since the GaAs layer 121 doped with the p-type impurity at a high impurity concentration is used as a portion of the gate electrode, the height of the potential barrier against the electrons can be further elevated. The potential barrier at a gate electrode side in the heterojunction FET shown in Fig. 6 is higher than that in the heterojunction FET shown in Fig. 1 by 0.4eV.

The heterojunction FET of this modification has the threshold voltage of 0.3V, the gate forward direction rising voltage of 1.5V, and the maximum drain current of 350mA/mm. Thus, by using the p-type GaAs layer 121 as a portion of the gate electrode, the gate forward direction rising voltage is further elevated. As a result, the gate forward direction rising voltage becomes higher than that of the heterojunction FET shown in Fig. 1 by 0.4V.

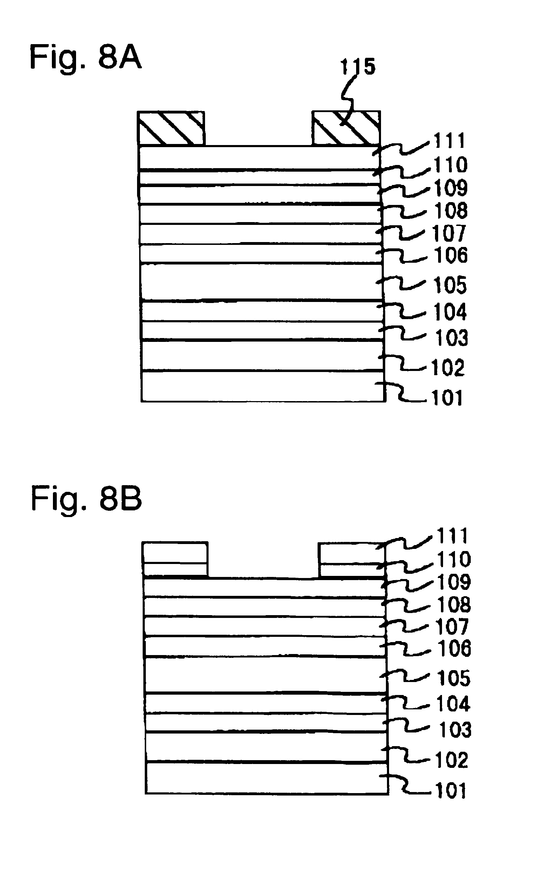

Now, a process for fabricating the heterojunction FET shown in Fig. 6 will be described with reference to Figs. 8A to 8F, which are diagrammatic sectional views illustrating a process for fabricating the heterojunction FET shown in Fig. 6.

Since Figs. 8A and 8B correspond to Figs. 5A and 5B, respectively, an explanation for an epitaxial process will be omitted.

As shown in Fig. 8A, a patterned mask 115 having an opening corresponding to a wide recess is formed on the GaAs cap layer 111 of the substrate thus formed. The GaAs cap layer 111 is selectively etched by using the patterned mask 115 as an etching mask to form a wide recess, and the Al_{0.2}Ga_{0.8}As wide recess stopper layer 110 is selectively etched.

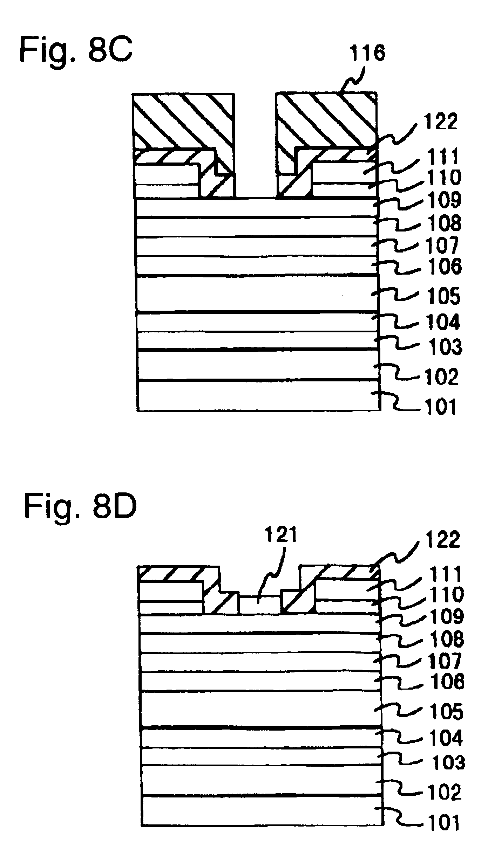

After the mask 115 is removed as shown in Fig. 8B, an SiO₂ film 122 is formed on the whole surface. Then, a new mask 116 having an opening corresponding to a gate is formed on SiO₂ film 122 as shown in Fig. 8C. The SiO₂ film 122 is selectively removed by using the mask 116. After the mask 116 is removed, a GaAs layer 121 doped with a p-type impurity at an impurity concentration of 4×10¹⁹cm⁻³ and having a film thickness of 50nm is selectively grown in an opening formed in the SiO₂ film 122 by means of the organometallic vapor phase epitaxy, as shown in Fig. 8D.

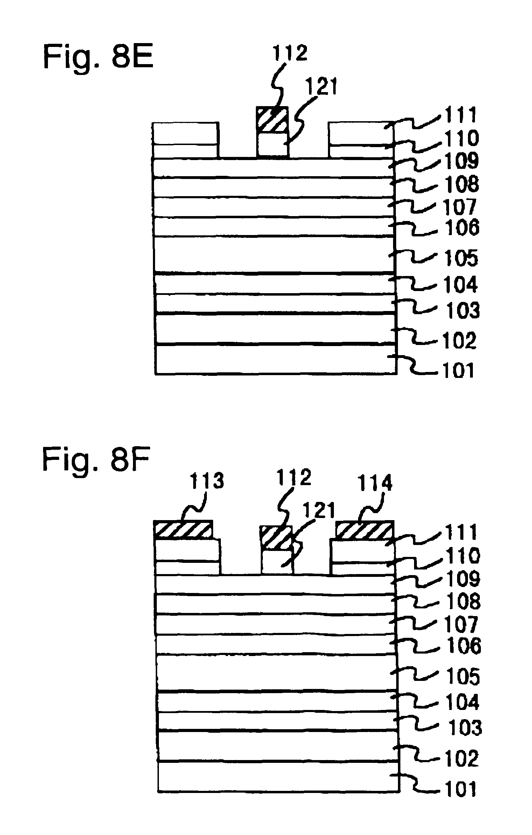

Thus, a WSi gate electrode 112 is formed on the selectively grown GaAs layer 121, as shown in Fig. 8E. Thereafter, an AuGe film is vaporized and lifted off, and then, a heat treatment is performed for alloying, so that the source electrode 113 and the drain electrode 114 are formed as shown in Fig. 8F.

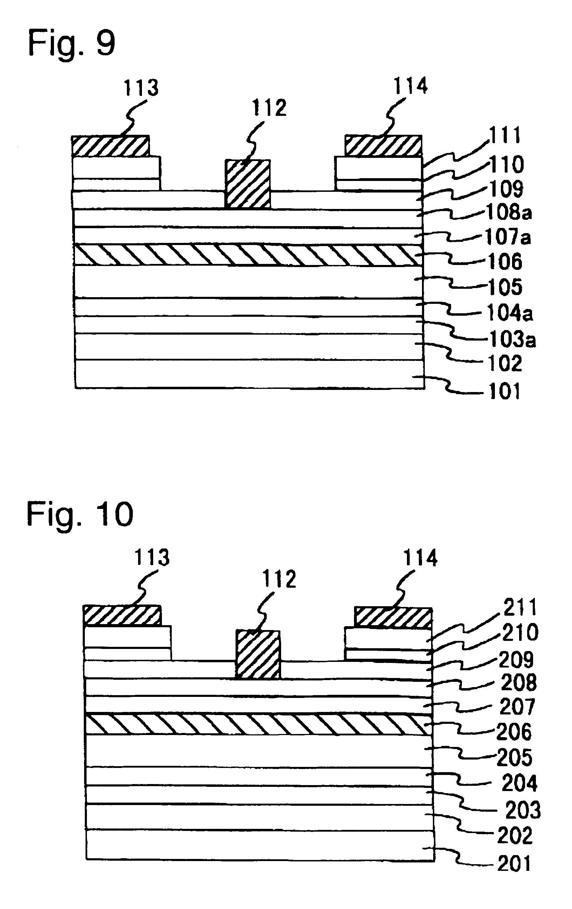

Fig. 9 is a diagrammatic sectional view of another modification of the first embodiment of the FET in accordance with the present invention. The shown modification of the heterojunction FET is characterized in that the upper and lower Al_{0.2}Ga_{0.8}As electron supplying layers 107 and 103 are replaced with In_{0.5}Ga_{0.5}P electron supplying layers 107a and 103a, respectively, the AlGaAs spacer layer 104 under the channel layer is replaced with an In_{0.5}Ga_{0.5}P spacer layer 104a, and the AlGaAs gate contact layer 108 is replaced with an In_{0.5}Ga_{0.5}P gate contact layer 108a.

This modification of the heterojunction FET has the threshold voltage of +0.3V, the gate forward direction rising voltage of +1.1V. The maximum drain current is as large as 350mA/mm. In addition, a gate-drain reverse-direction breakdown voltage is increased by 3V in comparison with heterojunction FET shown in Fig. 1.

An impact ionization percent in the InGaP layer is lower than that in the AlGaAs layer. Therefore, by forming the electron supplying layer of the InGaP layer, it is possible to suppress the impact ionization occurring within the electron supplying layer under a high electric field generated when a gate-drain reverse-direction bias is applied, so that a reverse-direction gate current is reduced. Accordingly, a large gate-drain breakdown voltage can be obtained.

Fig. 10 is a diagrammatic sectional view of still another modification of the first embodiment of the FET in accordance with the present invention. This modification of the heterojunction FET is characterized in that an undoped (Al_{0.5}Ga_{0.5})_{0.5}In_{0.5}P barrier layer 206 having a film thickness of 5nm is formed between an undoped In_{0.2}Ga_{0.8}As channel layer 205 and an In_{0.5}Ga_{0.5}P upper electron supplying layer 207.

In this modification, a barrier layer is formed which is higher than that in the prior art using the Al_{0.2}Ga_{0.8}As spacer layer, by 0.15eV in the Γ valley. This modification of the heterojunction FET has the threshold voltage of +0.3V. The gate forward direction rising voltage is +1.0V, and the maximum drain current is as large as 350mA/mm.

Now, a process for fabricating the heterojunction FET shown in Fig. 10 will be briefly described.

Similarly to the process explained with reference to Figs. 5A to 5F, on the semi-insulative GaAs substrate 201, by means of an organometallic vapor phase epitaxy there are epitaxially grown in the named order an undoped Al_{0.2}Ga_{0.8}As buffer layer 202 having a film thickness of 500nm, an In_{0.5}Ga_{0.5}P electron supplying layer 203 doped with Si at an impurity concentration of 4×10¹⁸cm⁻³ and having a film thickness of 4nm, an undoped In_{0.5}Ga_{0.5}P layer 204 having a film thickness of 2nm, an undoped In_{0.2}Ga_{0.8}As channel layer 205 having a film thickness of 15nm, an undoped (Al_{0.5}Ga_{0.5})_{0.5}In_{0.5}P barrier layer 206 having a film thickness of 5nm, an In_{0.5}Ga_{0.5}P electron supplying layer 207 doped with Si at an impurity concentration of 4×10¹⁸cm⁻³ and having a film thickness of 9nm, an undoped In_{0.5}Ga_{0.5}P gate contact layer 208 having a film thickness of 5nm, an undoped GaAs gate buried layer 209 having a film thickness of 15nm, an Al_{0.2}Ga_{0.8}As wide recess stopper layer 210 having a film thickness of 5nm, and a GaAs cap layer 211 doped with Si at an impurity concentration of 4×10¹⁸cm⁻³ and having a film thickness of 100nm. Thereafter, the gate electrode 112, the source electrode 113 and the drain electrode 114 are formed similarly to the process explained with reference to Figs. 5A to 5F.

In this modification, the barrier layer is constituted of a (Al_{X}Ga₁₋ _{X})_{Y}In_{1-Y}P layer having X=0.5 and Y=0.5 and the film thickness of 5nm. However, if the film thickness is not less than 3nm but not greater than 10nm, and if the condition of 0.2≤X≤1 and 0.4<Y<0.6 is satisfied, it is possible to elevate the gate forward direction rising voltage without deteriorating the maximum drain current and the on-resistance.

In addition, in this modification, the upper and lower electron supplying layers, the spacer layer under the channel layer and the gate contact layer are constituted of the InGaP layer, but can be constituted of an AlGaAs layer.

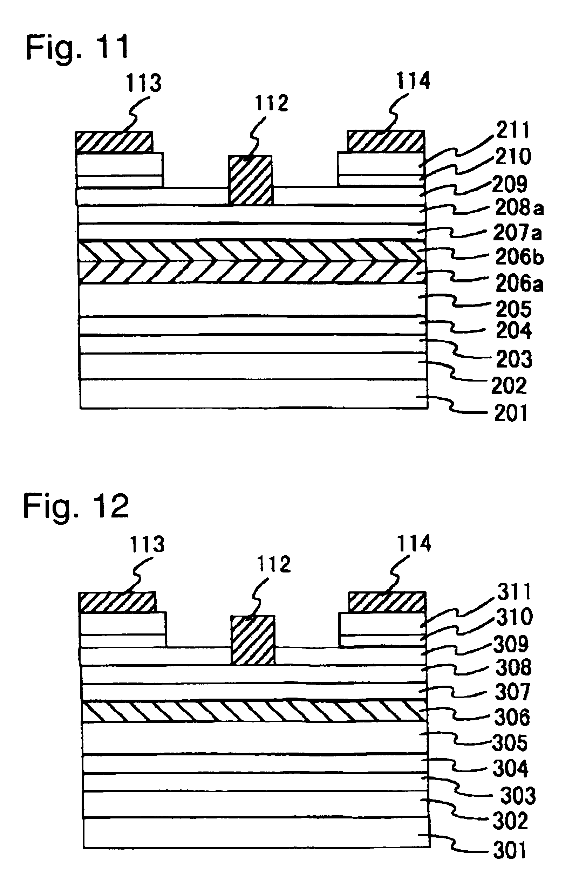

Fig. 11 is a diagrammatic sectional view of a further modification of the first embodiment of the FET in accordance with the present invention. This modification of the heterojunction FET is characterized in that the undoped (Al_{0.5}Ga_{0.5})_{0.5}In_{0.5}P barrier layer 206 having the film thickness of 5nm, shown in Fig. 10 is replaced with a stacked barrier layer constituted of an undoped (Al_{0.5}Ga_{0.5})_{0.5}In_{0.5}P barrier layer 206a having a film thickness of 2nm, and an (Al_{0.3}Ga_{0.7})_{0.5}In_{0.5}P barrier layer 206b formed on the barrier layer 206a and doped with Si at an impurity concentration of 4×10¹⁸cm⁻³ and having a film thickness of 3nm.

This modification of the heterojunction FET has the threshold voltage of +0.3V. The gate forward direction rising voltage is +1.0V, and the maximum drain current is as large as 350mA/mm. By doping the impurity into a portion of the barrier layer as in this modification, the distance between the channel layer and the impurity-doped electron supplying layer equivalently becomes short, with the result that the amount of carriers accumulated in the channel layer increases, and the maximum drain current correspondingly increases.

An epitaxially stacked structure of this modification of the heterojunction FET shown in Fig. 11 can be formed by epitaxially growing in the named order, on the semi-insulative GaAs substrate 201, by means of an organometallic vapor phase epitaxy, an undoped Al_{0.2}Ga_{0.8}As buffer layer 202 having a film thickness of 500nm, an In_{0.5}Ga_{0.5}P electron supplying layer 203 doped with Si at an impurity concentration of 4×10¹⁸cm⁻³ and having a film thickness of 4nm, an undoped In_{0.5}Ga_{0.5}P layer 204 having a film thickness of 2nm, an undoped In_{0.2}Ga_{0.8}As channel layer 205 having a film thickness of 15nm, an undoped (Al_{0.5}Ga_{0.5})_{0.5}In_{0.5}P barrier layer 206 having a film thickness of 2nm, an (Al_{0.3}Ga_{0.7})_{0.5}In_{0.5}P barrier layer 206b doped with Si at an impurity concentration of 4×10¹⁸cm⁻³ and having a film thickness of 3nm, an In_{0.5}Ga_{0.5}P electron supplying layer 207a doped with Si at an impurity concentration of 4×10¹⁸cm⁻³ and having a film thickness of 7nm, an undoped In_{0.5}Ga_{0.5}P gate contact layer 208a having a film thickness of 7nm, an undoped GaAs gate buried layer 209 having a film thickness of 15nm, an Al_{0.2}Ga_{0.8}As wide recess stopper layer 210 having a film thickness of 5nm, and a GaAs cap layer 211 doped with Si at an impurity concentration of 4×10¹⁸cm⁻³ and having a film thickness of 100nm.

In this modification, the Si-doped barrier layer is constituted of an (Al_{X}Ga_{1-X})_{0.5}In_{0.5}P layer having X=0.3. However, it is sufficient if the n-type impurity doped layer is constituted of an (Al_{X}Ga_{1-X})_{0.5}In_{0.5}P layer where 0.2≤X≤0.3, which does not cause the problem of the DX center. In addition, if the semiconductor barrier layer is formed of an (Al_{X}Ga_{1-X})_{Y}In_{1-Y}P layer where 0.2≤X≤0.3 and 0.4≤Y≤1.0 (X is not greater than 0.3) or an (Al_{X}Ga_{1-X})_{Y}In_{1-Y}P layer where 0.4≤X≤1 and 0.6<Y≤0.7 (the aluminum composition ratio XY is less than 0.7), since the problem of the DX center does not occur, it is possible to dope impurity into the barrier layer.

In addition, in this modification, the upper and lower electron supplying layers, the spacer layer under the channel layer and the gate contact layer are constituted of the InGaP layer, but can be constituted of an AlGaAs layer.

Fig. 12 is a diagrammatic sectional view of a still further modification of the first embodiment of the FET in accordance with the present invention. This modification of the heterojunction FET is characterized in that an undoped (Al_{0.5}Ga_{0.5})_{0.7}In_{0.3}P barrier layer 306 having a film thickness of 5nm is formed between an undoped In_{0.2}Ga_{0.8}As channel layer 305 and an In_{0.5}Ga_{0.5}P upper electron supplying layer 307.

Since an (Al_{X}Ga_{1-X})_{Y}In_{1-Y}P layer where 0≤X≤1 and 0.5<Y is in lattice mismatching with the GaAs substrate, it is necessary to use the film with a film thickness which is not greater than a maximum film thickness where a defect such as dislocation never occurs. This maximum film thickness will be called a critical film thickness in this specification. The critical film thickness was examined when an (Al_{0.5}Ga_{0.5})_{Y}In_{1-Y}P layer is epitaxially grown while changing the composition ratio Y. Here, A1P and GaP have substantially the same lattice constant. Therefore, even if the composition ratio X is changed, since the critical film thickness is not influenced, X=0.5 was used.

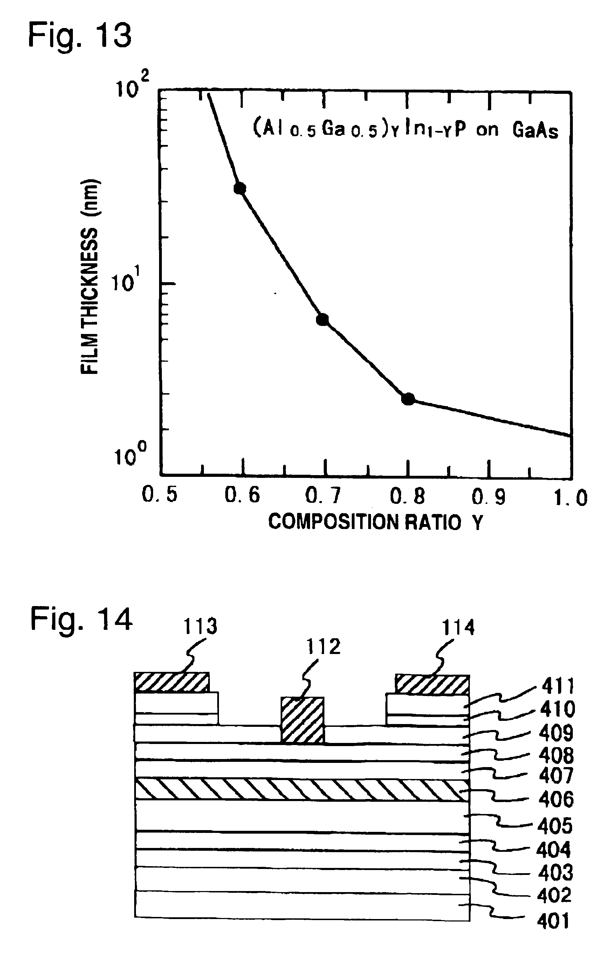

Fig. 13 illustrates a dependency to the composition ratio Y of the critical film thickness of the (Al_{0.5}Ga_{0.5})_{Y}In_{1-Y}P film grown on a GaAs substrate. A high quality (Al_{X}Ga_{1-X})_{Y}In_{1-Y}P layer where 0≤X≤1 and 0.5<Y, having no dislocation, can be obtained if the film thickness is not greater than the critical film thickness. For example, if Y=0.7, the critical film thickness is 7nm. In this modification, the harrier layer is constituted of the undoped (Al_{0.5}Ga_{0.5})_{0.7}In_{0.3}P layer having the film thickness of 5nm.

In this modification, a barrier layer is formed which is higher than that in the prior art using the Al_{0.2}Ga_{0.8}As spacer layer, by 0.3eV in the Γ valley. This modification of the heterojunction FET has the threshold voltage of +0.3V. The gate forward direction rising voltage is +1.2V, which is higher than that in the prior art heterojunction FET by 0.5V, and the maximum drain current is as large as 350mA/mm.

Now, a process for fabricating the heterojunction FET shown in Fig. 12 will be briefly described.

Similarly to the process explained with reference to Figs. 5A to 5F, an epitaxially stacked structure of the heterojunction FET shown in Fig. 12 can be formed by epitaxially growing in the named order, on the semi-insulative GaAs substrate 301, by means of an organometallic vapor phase epitaxy, an undoped Al_{0.2}Ga_{0.8}As buffer layer 302 having a film thickness of 500nm, an In_{0.5}Ga_{0.5}P electron supplying layer 303 doped with Si at an impurity concentration of 4×10¹⁸cm⁻³ and having a film thickness of 4nm, an undoped In_{0.5}Ga_{0.5}P layer 304 having a film thickness of 2nm, an undoped In_{0.2}Ga_{0.8}As channel layer 305 having a film thickness of 15nm, an undoped (Al_{0.5}Ga_{0.5})_{0.7}In_{0.3}P barrier layer 306 having a film thickness of 5nm, an In_{0.5}Ga_{0.5}P electron supplying layer 307 doped with Si at an impurity concentration of 4×10¹⁸cm⁻³ and having a film thickness of 9nm, an undoped In_{0.5}Ga_{0.5}P gate contact layer 308 having a film thickness of 5nm, an undoped GaAs gate buried layer 309 having a film thickness of 15nm, an Al_{0.2}Ga_{0.8}As wide recess stopper layer 310 having a film thickness of 5nm, and a GaAs cap layer 311 doped with Si at an impurity concentration of 4×10¹⁸cm⁻³ and having a film thickness of 100nm. Thereafter, the gate electrode 112, the source electrode 113 and the drain electrode 114 are formed similarly to the process explained with reference to Figs. 5A to 5F.

In this modification, the barrier layer is constituted of a (Al_{X}Ga₁₋ _{X})_{Y}In_{1-Y}P layer having X=0.5 and Y=0.7 and the film thickness of 5nm. However, if the film thickness is not less than 3nm but not greater than the critical film thickness and if the condition of 0≤X≤1 and 0.4≤Y≤0.8 is satisfied, it is possible to elevate the gate forward direction rising voltage without deteriorating the maximum drain current and the on-resistance. Here, if Y>0.8, the critical film thickness becomes less than 3nm, it is not longer suitable as a barrier layer.

In addition, in this modification, the upper and lower electron supplying layers, the spacer layer under the channel layer and the gate contact layer are constituted of the InGaP layer, but can be constituted of an AlGaAs layer.

Fig. 14 is a diagrammatic sectional view of a further modification of the first embodiment of the FET in accordance with the present invention. This modification of the heterojunction FET is characterized in that the substrate is constituted of an InP substrate, and an undoped Al_{0.7}In_{0.3}As barrier layer 406 having a film thickness of 5nm is formed between an undoped In_{0.53}Ga_{0.47}As channel layer 405 and an Al_{0.48}In_{0.52}As upper electron supplying layer 407.

Since an Al_{X}In_{1-X}As layer where 0.48<X is in lattice mismatching with the InP substrate, it is necessary to use the film with a film thickness which is not greater than a critical film thickness. The critical film thickness was examined when an Al_{X}In_{1-X}As layer where 0.5<X is epitaxially grown on the InP substrate while changing the composition ratio X.

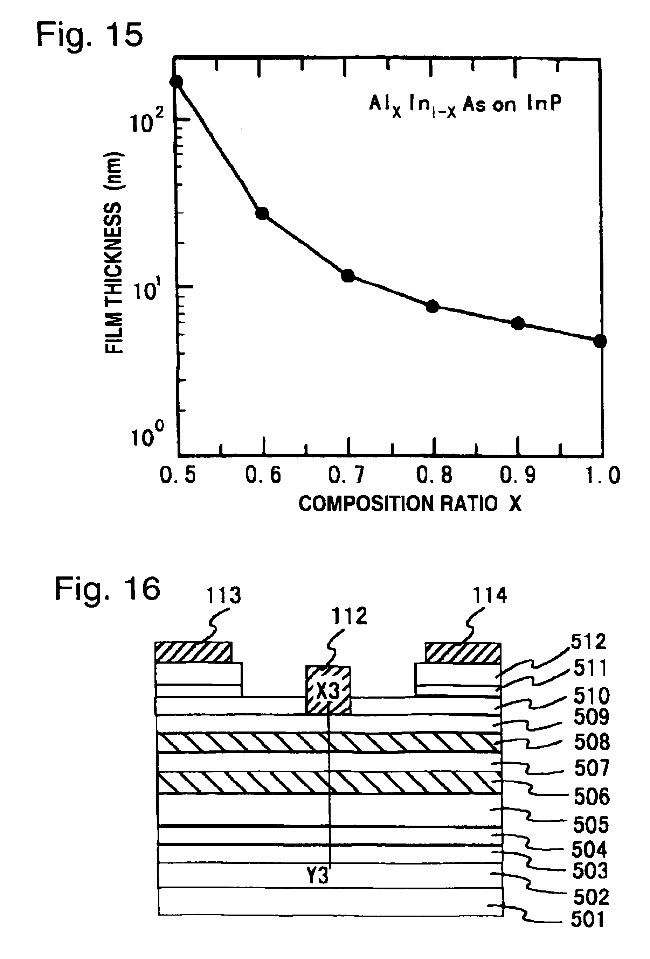

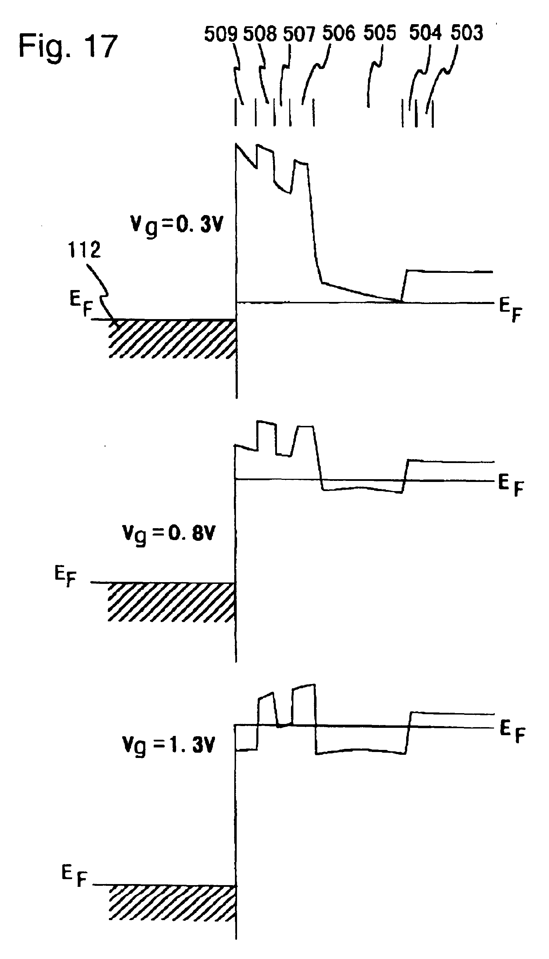

Fig. 15 illustrates a dependency to a composition ratio X of a critical film thickness of the Al_{X}In_{1-X}As film grown on the InP substrate. A high quality Al_{X}In_{1-X}As layer where 0.5<X, having no dislocation, can be obtained if the film thickness is not greater than the critical film thickness. For example, if X=0.7, the critical film thickness is 14nm. In this modification, the barrier layer is constituted of the Al_{0.7}In_{0.3}As layer having the film thickness of 5nm.

In this modification, a barrier layer is formed which is higher than that in the prior art using the Al_{0.2}Ga_{0.8}As spacer layer, by 0.3eV in the Γ valley. This modification of the heterojunction FET has the threshold voltage of +0.3V. The gate forward direction rising voltage is +1.2V, which is higher than that in the prior art heterojunction FET by 0.5V, and the maximum drain current is as large as 450mA/mm.

Now, a process for fabricating the heterojunction FET shown in Fig. 14 will be briefly described.

Similarly to the process explained with reference to Figs. 5A to 5F, an epitaxially stacked structure of the heterojunction FET shown in Fig. 14 can be formed by epitaxially growing in the named order, on the semi-insulative InP substrate 401, by means of a molecular beam epitaxy or an organometallic vapor phase epitaxy, an undoped Al_{0.48}In_{0.52}As buffer layer 402 having a film thickness of 500nm, an Al_{0.4}In_{0.52}As electron supplying layer 403 doped with Si at an impurity concentration of 4×10¹⁸cm⁻³ and having a film thickness of 2nm, an undoped Al_{0.48}In_{0.52}As layer 404 having a film thickness of 2nm, an undoped In_{0.53}Ga_{0.47}As channel layer 405 having a film thickness of 15nm, an undoped Al_{0.7}In_{0.3}As barrier layer 406 having a film thickness of 5nm, an Al_{0.48}In_{0.52}As electron supplying layer 407 doped with Si at an impurity concentration of 4×10¹⁸cm⁻³ and having a film thickness of 7nm, an undoped In_{0.48}Ga_{0.52}As gate contact layer 408 having a film thickness of 5nm, an undoped In_{0.53}Ga_{0.47}As gate buried layer 409 having a film thickness of 15nm, an Al_{0.48}In_{0.52}As wide recess stopper layer 410 having a film thickness of 5nm, and an In_{0.53}Ga_{0.47}As cap layer 411 doped with Si at an impurity concentration of 1×10¹⁹cm⁻³ and having a film thickness of 100nm. Thereafter, the gate electrode 112, the source electrode 113 and the drain electrode 114 are formed similarly to the process explained with reference to Figs. 5A to 5F.

In this modification, the barrier layer is constituted of a (Al_{X}Ga₁₋ _{X})_{Y}In_{1-Y}P layer having X=1.0 and Y=0.7 and the film thickness of 5nm. However, if the film thickness is not less than 3nm but not greater than the critical film thickness and if the condition of 0.4≤X≤1 and 0.6≤Y≤1 is satisfied, it is possible to elevate the gate forward direction rising voltage without deteriorating the maximum drain current and the on-resistance.

In addition, if the semiconductor barrier layer is formed of an (Al_{X}Ga_{1-X})_{Y}In_{1-Y}As layer where 0.4≤X≤1 and 0.6≤Y<0.7, since the problem of the DX center does not occur, it is possible to dope impurity into the barrier layer, so that the sheet carrier concentration in the channel layer can be elevated.

In this modification of the heterojunction FET, an AlInAs/InGaAs multilayer structure are epitaxially grown on the InP substrate. However, the gate forward direction rising voltage can be elevated by providing the barrier layer in a heterojunction FET including an AlGaInAs/InGaAs multilayer structure epitaxially grown on an InP substrate, and a hcterojunction FET including an AlInAs/InGaAs multilayer structure epitaxially grown on a buffer layer which is formed on a GaAs substrate for relaxing a lattice mismatching.

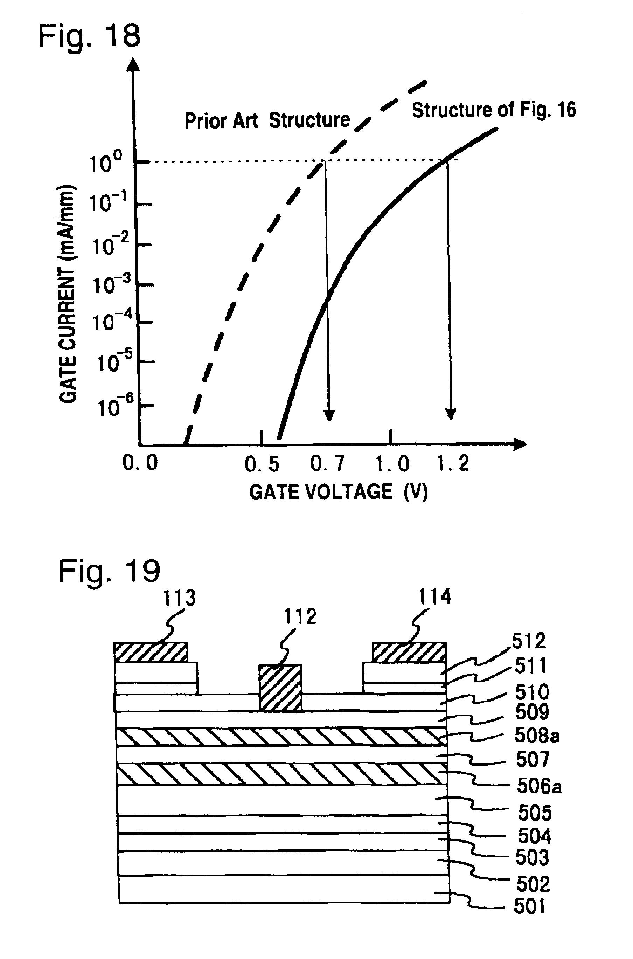

Referring to Fig. 16, there is shown a diagrammatic sectional view of a heterojunction FET which is a second embodiment of the FET in accordance with the present invention. This second embodiment of the heterojunction FET is characterized by having a double barrier structure in which an undoped Al_{0.5}Ga_{0.5}As barrier layer 506 having a film thickness of 4nm is formed between an undoped In_{0.2}Ga_{0.8}As channel layer 505 and an Si-doped Al_{0.2}Ga_{0.8}As upper electron supplying layer 507, and an undoped Al_{0.5}Ga_{0.5}As barrier layer 508 having a film thickness of 4nm is formed between the Si-doped Al_{0.2}Ga_{0.8}As upper electron supplying layer 507 and an undoped Al_{0.2}Ga_{0.8}As gate contact layer 509.

Fig. 17 illustrates a conduction band profile in the X3-Y3 direction in Fig. 16 when various voltages "Vg" of +0.3V, +0.8V and +1.3V are applied to the gate electrode 112. If a gate bias voltage "Vg" is not greater than 0.3V, a potential barrier formed near to the gate effectively functions, and if the gate bias voltage "Vg" is increased to exceed 0.3V, the height of the potential barrier formed near to the gate becomes low, but a potential barrier formed just above the channel does not lower, with the result that the potential barrier formed just above the channel effectively functions

Fig. 18 illustrates a gate voltage dependency of the gate forward direction current. As seen from Fig. 18, this embodiment of the heterojunction FET has a threshold voltage of +0.3V, and the gate forward direction rising voltage is +1.2V. The gate current is reduced over a wide gate voltage range. The gate forward direction rising voltage is higher than that in the first embodiment shown in Fig. 1 by 0.1V and also is higher than that in the prior art heterojunction FET by 0.5V. In addition, since the heterojunction FET has the double doped structure having the electron supplying layers formed above and under the channel layer, respectively, the maximum drain current is as large as 340mA/mm.

Now, a process for fabricating the heterojunction FET shown in Fig. 16 will be briefly described. Similarly to the process explained with reference to Figs. 5A to 5F, an epitaxially stacked structure of the heterojunction FET shown in Fig. 16 can be formed by epitaxially growing in the named order, on the semi-insulative GaAs substrate 501, by means of a molecular beam epitaxy or an organometallic vapor phase epitaxy, an undoped Al_{0.2}Ga_{0.8}As buffer layer 502 having a film thickness of 500nm, an Al_{0.2}Ga_{0.8}As electron supplying layer 503 doped with Si at an impurity concentration of 4×10¹⁸cm⁻³ and having a film thickness of 4nm, an undoped Al_{0.2}Ga_{0.8}As layer 504 having a film thickness of 2nm, an undoped In_{0.2}Ga_{0.8}As channel layer 505 having a film thickness of 15nm, an undoped Al_{0.5}Ga_{0.5}As barrier layer 506 having a film thickness of 4nm, an Al_{0.2}Ga_{0.8}As electron supplying layer 507 doped with Si at an impurity concentration of 4×10¹⁸cm⁻³ and having a film thickness of 8nm, an undoped Al_{0.5}Ga_{0.5}As barrier layer 508 having a film thickness of 4nm, an undoped Al_{0.2}Ga_{0.8}As gate contact layer 509 having a film thickness of 4nm, an undoped GaAs gate buried layer 510 having a film thickness of 15nm, an Al_{0.2}Ga_{0.8}As wide recess stopper layer 511 having a film thickness of 5nm, and a GaAs cap layer 512 doped with Si at an impurity concentration of 4×10¹⁸cm⁻³ and having a film thickness of 100nm.

In the above mentioned second embodiment, the Al_{0.5}Ga_{0.5}As barrier layers 506 and 508 having the film thickness of 4nm, are provided as the barrier layer. If each of the Al_{0.5}Ga_{0.5}As barrier layers 506 and 508 has the film thickness of not less than 3nm but not greater than lOnm and if the aluminum composition ratio is not less than 0.4, it is possible to elevate the gate forward direction rising voltage without deteriorating the maximum drain current and the on-resistance.

Fig. 19 is a diagrammatic sectional view of a modification of the second embodiment of the FET in accordance with the present invention. This modification of the second embodiment is characterized in that the Al_{0.5}Ga_{0.5}As barrier layers 506 and 508 having the film thickness of 4nm, shown in Fig. 16, are replaced with undoped (Al_{0.3}Ga_{0.7})_{0.5}In_{0.5}P barrier layers 506a and 508a having a film thickness of 4nm, respectively. This modification of the second embodiment has the threshold voltage of +0.3V. The gate forward direction rising voltage is +1.3V, and the maximum drain current is as large as 340mA/mm.

Now, a process for fabricating the heterojunction FET shown in Fig. 19 will be briefly described. Similarly to the process explained with reference to Figs. 5A to 5F, an epitaxially stacked structure of the heterojunction FET shown in Fig. 19 can be formed by epitaxially growing in the named order, on the semi-insulative GaAs substrate 501, by means of a molecular beam epitaxy or an organometallic vapor phase epitaxy, an undoped Al_{0.2}Ga_{0.8}As buffer layer 502 having a film thickness of 500nm, an Al_{0.2}Ga_{0.8}As electron supplying layer 503 doped with Si at an impurity concentration of 4×10¹⁸cm⁻³ and having a film thickness of 4nm, an undoped Al_{0.2}Ga_{0.8}As layer 504 having a film thickness of 2nm, an undoped In_{0.2}Ga_{0.8}As channel layer 505 having a film thickness of 15nm, an undoped (Al_{0.3}Ga_{0.7})_{0.5}In_{0.5}P barrier layer 506a having a film thickness of 4nm, an Al_{0.2}Ga_{0.8}As electron supplying layer 507 doped with Si at an impurity concentration of 4×10¹⁸cm⁻³ and having a film thickness of 8nm, an undoped (Al_{0.3}Ga_{0.7})_{0.5}In_{0.5}P barrier layer 508a having a film thickness of 4nm, an undoped Al_{0.2}Ga_{0.8}As gate contact layer 509 having a film thickness of 4nm, an undoped GaAs gate buried layer 510 having a film thickness of 15nm, an Al_{0.2}Ga_{0.8}As wide recess stopper layer 511 having a film thickness of 5nm, and a GaAs cap layer 512 doped with Si at an impurity concentration of 4×10¹⁸cm⁻³ and having a film thickness of 100nm.

In the above mentioned modification, the (Al_{X}Ga_{1-X})_{0.5}In_{0.5}P barrier layers 506a and 508a having X=0.3 and the film thickness of 4nm, are provided as the barrier layer. If each of the (Al_{X}Ga_{1-X})_{0.5}In_{0.5}P barrier layers has the film thickness of not less than 3nm but not greater than 10nm and if the aluminum composition ratio is in the range of 0.2≤X≤1, it is possible to elevate the gate forward direction rising voltage without deteriorating the maximum drain current and the on-resistance.

In addition, if the barrier layers are constituted of an (Al_{X}Ga₁₋ _{X})_{0.5}In_{0.5}P layer where 0.2≤X≤0.3, since the problem of the DX center does not occur, it is possible to dope impurity into the barrier layer, so that the sheet carrier concentration in the channel layer can be elevated.

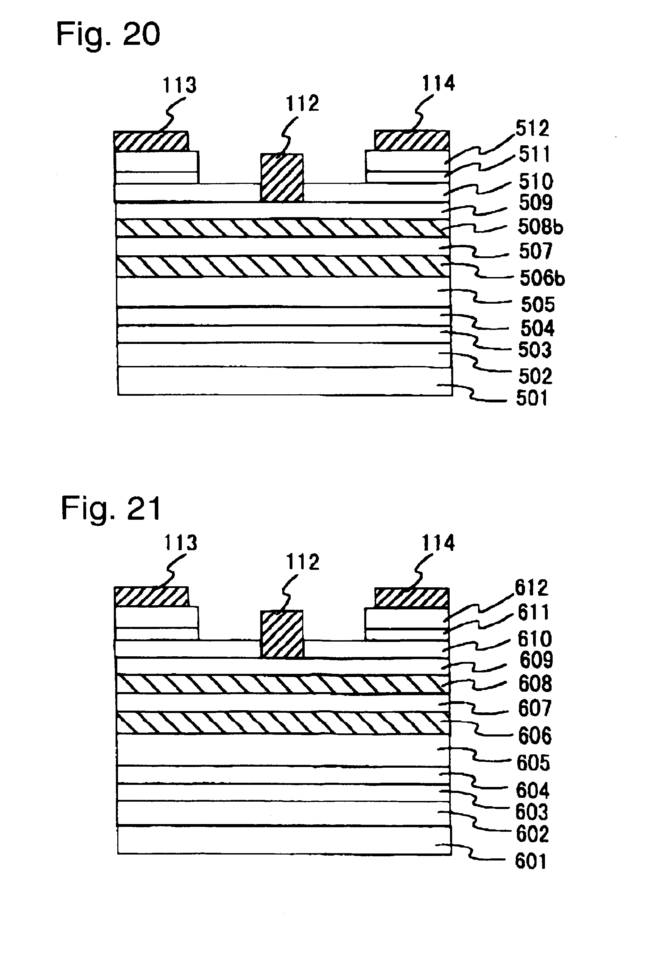

Fig. 20 is a diagrammatic sectional view of another modification of the second embodiment of the FET in accordance with the present invention. This modification of the second embodiment is characterized in that the undoped Al_{0.5}Ga_{0.5}As barrier layers 506 and 508 having the film thickness of 4nm, shown in Fig. 16, are replaced with undoped (Al_{0.3}Ga_{0.7})_{0.7}In_{0.3}P barrier layers 506b and 508b having a film thickness of 4nm, respectively. This modification of the second embodiment has the threshold voltage of +0.3V. The gate forward direction rising voltage is +1.3V, and the maximum drain current is as large as 340mA/mm.

Now, a process for fabricating the heterojunction FET shown in Fig. 20 will be briefly described. Similarly to the process explained with reference to Figs. 5A to 5F, an epitaxially stacked structure of the heterojunction FET shown in Fig. 20 can be formed by epitaxially growing in the named order, on the semi-insulative GaAs substrate 501, by means of a molecular beam epitaxy or an organometallic vapor phase epitaxy, an undoped Al_{0.2}Ga_{0.8}As buffer layer 502 having a film thickness of 500nm, an Al_{0.2}Ga_{0.8}As electron supplying layer 503 doped with Si at an impurity concentration of 4×10¹⁸cm⁻³ and having a film thickness of 4nm, an undoped Al_{0.2}Ga_{0.8}As layer 504 having a film thickness of 2nm, an undoped In_{0.2}Ga_{0.8}As channel layer 505 having a film thickness of 15nm, an undoped (Al_{0.3}Ga_{0.7})_{0.7}In_{0.3}P barrier layer 506b having a film thickness of 4nm, an Al_{0.2}Ga_{0.8}As electron supplying layer 507 doped with Si at an impurity concentration of 4×10¹⁸cm⁻³ and having a film thickness of 8nm, an undoped (Al_{0.3}Ga_{0.7})_{0.7}In_{0.3}P barrier layer 508b having a film thickness of 4nm, an undoped Al_{0.2}Ga_{0.8}As gate contact layer 509 having a film thickness of 4nm, an undoped GaAs gate buried layer 510 having a film thickness of 15nm, an Al_{0.2}Ga_{0.8}As wide recess stopper layer 511 having a film thickness of 5nm, and a GaAs cap layer 512 doped with Si at an impurity concentration of 4×10¹⁸cm⁻³ and having a film thickness of 100nm.

In the above mentioned modification, the (Al_{X}Ga_{1-X})_{Y}In_{1-Y}P barrier layers 506b and 508b having X=0.3 and Y=0.7 and the film thickness of 4nm, are provided as the barrier layer. If each of the (Al_{X}Ga_{1-X})_{Y}In_{1-Y}P barrier layers has the film thickness of not less than 3nm but not greater than the critical film thickness and if the condition of 0.2≤X≤1 and 0.6≤Y≤0.8 is satisfied, it is possible to elevate the gate forward direction rising voltage without deteriorating the maximum drain current and the on-resistance.

In addition, if the barrier layers are constituted of an (Al_{X}Ga₁₋ _{X})_{Y}In_{1-Y}P layer where 0.2≤X≤0.3 and 0.6≤Y≤0.8, since the problem of the DX center does not occur, it is possible to dope impurity into the barrier layer, so that the sheet carrier concentration in the channel layer can be elevated.

Fig. 21 is a diagrammatic sectional view of still another modification of the second embodiment of the FET in accordance with the present invention. This modification of the heterojunction FET is characterized in that the substrate is constituted of an InP substrate, and an undoped Al_{0.7}In_{0.3}As barrier layer 606 having a film thickness of 4nm is formed between an undoped In_{0.53}Ga_{0.47}As channel layer 605 and an Al_{0.48}In_{0.52}As upper electron supplying layer 607, and an undoped Al_{0.7}In_{0.3}As barrier layer 608 having a film thickness of 4nm is formed between the Al_{0.48}In_{0.52}As upper electron supplying layer 607 and an Al_{0.48}In_{0.52}As gate contact layer 609.

This modification of the second embodiment has the threshold voltage of +0.3V. The gate forward direction rising voltage is +1.3V, and the maximum drain current is as large as 440mA/mm.

Now, a process for fabricating the heterojunction FET shown in Fig. 21 will be briefly described. Similarly to the process explained with reference to Figs. 5A to 5F, an epitaxially stacked structure of the heterojunction FET shown in Fig. 21 can be formed by epitaxially growing in the named order, on the semi-insulative InP substrate 601, by means of a molecular beam epitaxy or an organometallic vapor phase epitaxy, an undoped Al_{0.48}In_{0.52}As buffer layer 602 having a film thickness of 500nm, an Al_{0.48}In_{0.52}As electron supplying layer 603 doped with Si at an impurity concentration of 4×10¹⁸cm⁻³ and having a film thickness of 2nm, an undoped Al_{0.48}In_{0.52}As layer 604 having a film thickness of 2nm, an undoped In_{0.53}Ga_{0.47}As channel layer 605 having a film thickness of 15nm, an undoped Al_{0.7}In_{0.3}As barrier layer 606 having a film thickness of 4nm, an Al_{0.48}In_{0.52}As electron supplying layer 607 doped with Si at an impurity concentration of 4×10¹⁸cm⁻³ and having a film thickness of 7nm, an undoped Al_{0.7}In_{0.3}As barrier layer 608 having a film thickness of 4nm, an undoped In_{0.48}Ga_{0.52}As gate contact layer 609 having a film thickness of 5nm, an undoped In_{0.53}Ga_{0.47}As gate buried layer 610 having a film thickness of 15nm, an Al_{0.48}In_{0.52}As wide recess stopper layer 611 having a film thickness of 5nm, and an In_{0.53}Ga_{0.47}As cap layer 612 doped with Si at an impurity concentration of 1×10¹⁹cm⁻³ and having a film thickness of 100nm. Thereafter, the gate electrode 112, the source electrode 113 and the drain electrode 114 are formed similarly to the process explained with reference to Figs. 5A to 5F.

In this modification, the barrier layers are constituted of a (Al_{X}Ga_{1-X})_{Y}In_{1-Y}P layer having X=1.0 and Y=0.7 and the film thickness of 4nm. However, if the film thickness is not less than 3nm but not greater than the critical film thickness and if the condition of 0.4≤X≤1 and 0.6<Y≤1 is satisfied, it is possible to elevate the gate forward direction rising voltage without deteriorating the maximum drain current and the on-resistance.

In addition, if the semiconductor barrier layer is formed of an (Al_{X}Ga_{1-X})_{Y}In_{1-Y}As layer where 0.4≤X≤1 and 0.6≤Y<0.7, since the problem of the DX center does not occur, it is possible to dope impurity into the barrier layer, so that the sheet carrier concentration in the channel layer can be elevated.

In this modification of the heterojunction FET, an AlInAs/InGaAs multilayer structure are epitaxially grown on the InP substrate. However, the gate forward direction rising voltage can be elevated by providing the barrier layer in a heterojunction FET including an AlGaInAs/InGaAs multilayer structure epitaxially grown on an InP substrate, and a heterojunction FET including an AlInAs/InGaAs multilayer structure epitaxially grown on a buffer layer which is formed on a GaAs substrate for relaxing a lattice mismatching.

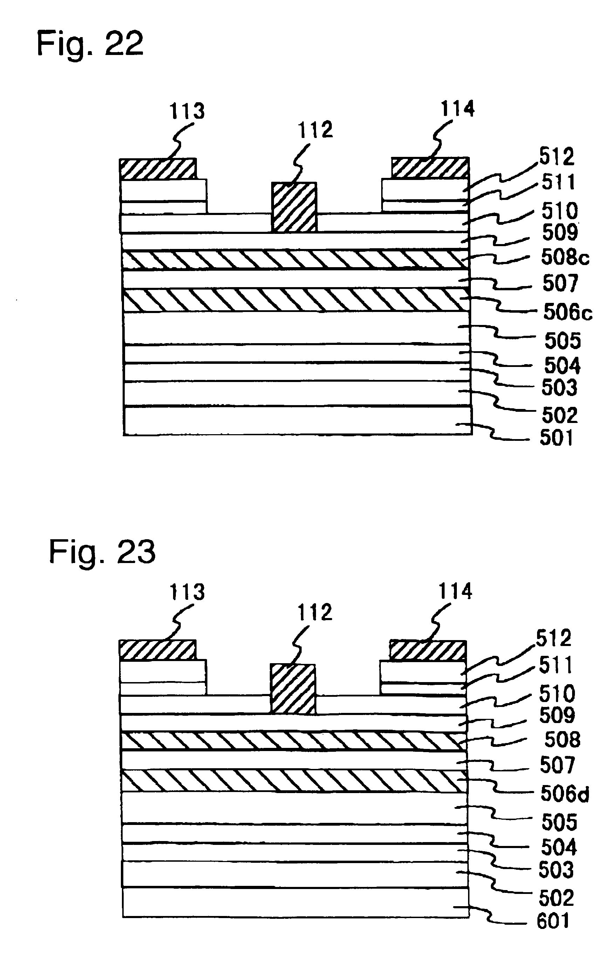

Fig. 22 is a diagrammatic sectional view of a further modification of the second embodiment of the FET in accordance with the present invention. This modification of the second embodiment is characterized in that the undoped Al_{0.5}Ga_{0.5}As barrier layer 506 having the film thickness of 4nm and the undoped Al_{0.5}Ga_{0.5}As barrier layer 508 having the film thickness of 4nm shown in Fig. 16, are replaced with an undoped Al_{0.8}Ga_{0.2}As barrier layer 506c having a film thickness of 5nm and an undoped Al_{0.4}Ga_{0.6}As barrier layer 508c having a film thickness of 4nm, respectively. In this modification, the barrier layers in the double barrier structure are asymmetrical in the film thickness and in the composition

This modification of the second embodiment has the threshold voltage of +0.3V. The gate forward direction rising voltage is +1.4V, and the maximum drain current is as large as 340mA/mm. As seen from this modification, even if the AlGaAs barrier layers having different film thicknesses and different aluminum composition ratios are used, it is possible to elevated the gate forward direction rising voltage. In this case, it is preferred that the barrier layer near to the channel layer has the aluminum composition ratio higher than that in the barrier layer remote from the channel layer.

Fig. 23 is a diagrammatic sectional view of a still further modification of the second embodiment of the FET in accordance with the present invention. This modification of the second embodiment is characterized in that the undoped Al_{0.5}Ga_{0.5}As barrier layer 506 having the film thickness of 4nm shown in Fig. 16, is replaced with an (Al_{0.3}Ga_{0.7})_{0.5}In_{0.5}P barrier layer 506d doped with Si at an impurity concentration of 4×10¹⁸cm⁻³ and having a film thickness of 4nm. In this modification, the barrier layers in the double barrier structure become asymmetrical by doping the impurity into one of the barrier layers in the double barrier structure.

This modification of the second embodiment has the threshold voltage of +0.3V. The gate forward direction rising voltage is +1.4V, and the maximum drain current is as large as 340mA/mm.

In this modification of the second embodiment, the impurity is doped into the barrier layer near to the channel layer. This is equivalent to the fact that the distance between the channel layer and the n-type impurity doped layer becomes short. Therefore, the amount of carriers accumulated in the channel layer increases, so that the maximum drain current increases. In addition, as in this modification of the second embodiment, when the two semiconductor barrier layers are formed, the two semiconductor barrier layers can be formed of different materials.

As mentioned above, the field effect transistor in accordance with the present invention can have a large maximum drain current, even if an ion implantation is not carried out for lowering the contact resistance. However, a contact ion implantation can be carried out in the field effect transistor in accordance with the present invention. In this case, of course, a further large drain current can be obtained.

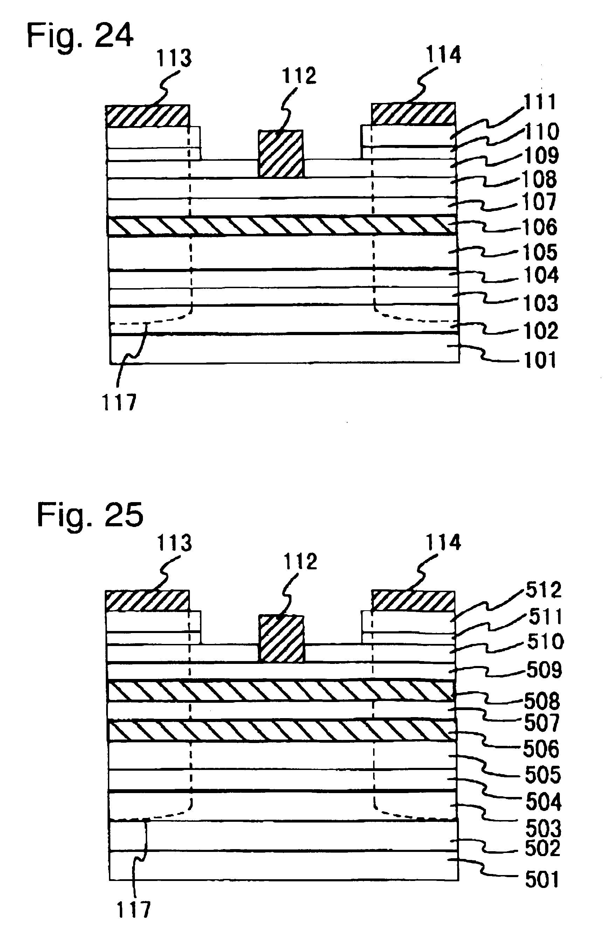

Fig. 24 is a diagrammatic sectional view of a further modification of the first embodiment of the FET in accordance with the present invention in which a contact ion implantation can be carried out. In Fig. 24, elements corresponding to those shown in Fig. 1 are given the same reference numbers, and explanation will be omitted.

In Fig. 24, the reference number 117 designates a contact ion implanted region. This modification of the first embodiment has the threshold voltage of +0.3V. The gate forward direction rising voltage is +1.1V, and the maximum drain current is as large as 380mA/mm, which becomes larger than that in the heterojunction FET shown in Fig. 1 by about 10%.

Thus, since the contact resistance between the channel layer and each of the source electrode and the drain electrode is reduced by the contact ion implantation, even if the number of steps in the fabricating process increases, a further large drain current can be obtained. The contact ion implanted region 117 can be formed by forming a mask having an opening corresponding to each of the source electrode and the drain electrode, by ion implanting Si ions at an acceleration energy of 150keV and a dose of 2×10¹³cm⁻² and by carrying out an activating heat-treatment at a temperature of 800°C for a time of five seconds.

Fig. 25 is a diagrammatic sectional view of a further modification of the second embodiment of the FET in accordance with the present invention in which a contact ion implantation can be carried out. In Fig. 25, elements corresponding to those shown in Fig. 16 are given the same reference numbers, and explanation will be omitted.

In Fig. 25, the reference number 117 designates a contact ion implanted region. This modification of the second embodiment has the threshold voltage of +0.3V. The gate forward direction rising voltage is +1.2V, and the maximum drain current is as large as 370mA/mm, which becomes larger than that in the heterojunction FET shown in Fig. 1 by about 10%. Incidentally, it is possible to use a re-grown n-type GaAs layer in place of the contact ion implantation.

Fig. 26 is a diagrammatic sectional view of a still further modification of the first embodiment of the FET in accordance with the present invention, in which a GaAs layer 118 doped with an n-type impurity at an impurity concentration of 4×10¹⁸cm⁻³ is epitaxially grown in a pair of ohmic contact regions in the heterojunction FET of the first embodiment of the present invention, and the source electrode 113 and the drain electrode 114 are formed on the GaAs layer 118.

This modification of the first embodiment has the threshold voltage of +0.3V. The gate forward direction rising voltage is +1.1V, and the maximum drain current is as large as 380mA/mm, which becomes larger than that in the heterojunction FET shown in Fig. 1 by about 10%.

As in the modification shown in Fig. 26, the contact resistance between the channel layer and each of the source electrode and the drain electrode is reduced by removing the barrier layers directly under the ohmic electrodes and by epitaxially growing a semiconductor layer doped with an n-type impurity at a high impurity concentration. As a result, a further large drain current can be obtained.

As seen from the above, according to the present invention, a potential barrier formed by a semiconductor barrier layer inserted between the channel layer and the upper electron supplying layer, effectively functions as a barrier when a forward direction gate bias is applied, so that a gate leak current is reduced in the forward direction gate biasing condition and a gate forward direction rising voltage can be elevated.

Furthermore, according to the present invention, not only a semiconductor barrier layer inserted between the channel layer and the upper electron supplying layer, but also another semiconductor barrier layer inserted between the upper electron supplying layer and the gate electrode. With this arrangement, in a low gate bias condition, a barrier near to the gate electrode reduces the gate current, and in a high gate bias condition, a barrier near to the channel reduces the gate current, so that a gate forward direction rising voltage can be elevated.

Moreover, according to the present invention, the film thickness of the semiconductor barrier layer is not less than 3nm but not greater than 10nm, or alternatively, not less than 3nm but not greater than the critical film thickness when the critical film thickness is less than 10nm. With this arrangement, since the semiconductor barrier layer is very thin, a tunnel current passing through the potential is sufficiently large. Therefore, a contact resistance between the channel layer and each of a source electrode and a drain electrode is not increased, and an ohmic characteristics is not deteriorated. Furthermore, since a distance between the upper electron supplying layer and the channel layer is short, a large number of electrons are accumulated in the channel layer, so that a maximum drain current can be increased.

In addition, according to the present invention, a channel layer side portion of the semiconductor barrier layer is in an undoped condition, but a gate electrode side portion of the semiconductor barrier layer is doped with an n-type impurity, so that a portion of the semiconductor barrier layer functions as an electron supplying layer. Accordingly, since the distance between the upper electron supplying layer and the channel layer becomes further short, a very large number of electrons are accumulated in the channel layer, so that a maximum drain current can be further increased.

Furthermore, according to the present invention, in the field effect transistor having the two semiconductor barrier layers, a portion or all of the semiconductor barrier layer near to a channel layer is doped with an n-type impurity. In this arrangement, since the distance between the upper electron supplying layer and the channel layer becomes further short, a very large number of electrons are accumulated in the channel layer, so that a maximum drain current can be further increased.

Moreover, according to the present invention, since the electron supplying layers can be located under and above the channel layer and near to the channel layer, a large number of electrons can be accumulated in the channel layer, so that a maximum drain current can be further increased.

The invention has thus been shown and described with reference to the specific embodiments. However, it should be noted that the present invention is in no way limited to the details of the illustrated structures but changes and modifications may be made within the scope of the appended claims.

Finally, the content of the basic Japanese Patent Application No. 361057/1999 filed on December 20, 1999 is incorporated by reference in its entirety into this application.

## Claims

1. A field effect transistor which includes at least a first semiconductor layer in which carriers flows, and a second semiconductor layer formed on said first semiconductor layer, said second semiconductor layer having an electron affinity smaller that of said first semiconductor layer, and said second semiconductor layer being doped with an n-type impurity, wherein a semiconductor barrier layer is inserted between said first semiconductor layer and said second semiconductor layer, said semiconductor barrier layer having a positive electron energy at a conduction band bottom of a Γ valley, in comparison with an electron energy at a conduction band bottom of a Γ valley in said second semiconductor layer, said semiconductor barrier layer having a film thickness of not less than 3nm but not greater than 10nm.

2. A field effect transistor claimed in Claim 1 wherein said semiconductor barrier layer is in lattice mismatching with a semiconductor substrate on which semiconductor layers are grown, and a maximum film thickness of said semiconductor barrier layer in which no dislocation occurs, is less than 10nm, said semiconductor barrier layer having the film thickness of not less than 3nm but not greater than the maximum film thickness in which no dislocation occurs.

3. A field effect transistor claimed in Claim 1 wherein said first semiconductor layer is formed of a material selected from the group consisting of InGaAs and GaAs, said second semiconductor layer is formed of a material selected from the group consisting of Al_{X₁}Ga_{1-X₁}As where 0≤X₁≤0.3, and InGaP, and said semiconductor barrier layer is formed of Al_{X₂}Ga_{1-X₂}As where 0.4≤X₂≤1.

4. A field effect transistor claimed in Claim 1 wherein said first semiconductor layer is formed of a material selected from the group consisting of InGaAs and GaAs, said second semiconductor layer is formed of a material selected from the group consisting of Al_{X₁}Ga_{1-X₁}As where 0≤X₁≤0.3, and InGaP, and said semiconductor barrier layer is formed of (Al_{X₂}Ga_{1-X₂})_{Y}In_{1-Y}P where 0.2≤X₂≤1, and 0.4<Y<0.6.

5. A field effect transistor claimed in Claim 1 wherein said first semiconductor layer is formed of a material selected from the group consisting of InGaAs and GaAs, said second semiconductor layer is formed of a material selected from the group consisting of Al_{X₁}Ga_{1-X₁}As where 0≤X₁≤0.3, and InGaP, and said semiconductor barrier layer is formed of (Al_{X₂}Ga_{1-X₂})_{Y}In_{1-Y}P where 0≤X₂≤1, and 0.6≤Y≤1.

6. A field effect transistor claimed in Claim 1 wherein said first semiconductor layer is formed of InGaAs, said second semiconductor layer is formed of a material selected from the group consisting of AlInAs and AlGaInAs, and said semiconductor barrier layer is formed of (Al_{X}Ga_{1-X})_{Y}In_{1-Y}As where 0.4≤X≤1, and 0.6≤Y≤1.

7. A field effect transistor claimed in Claim 4 wherein said semiconductor barrier layer is formed of a material selected from the group consisting of (Al_{X}Ga_{1-X})_{Y}In_{1-Y}P where 0.2≤X≤0.3, and 0.4<Y≤1.0 and (Al_{X}Ga_{1-X})_{Y}In_{1-Y}As where 0.4≤X≤1, and 0.6≤Y<0.7, and said semiconductor barrier layer having an undoped layer portion at a side of said first semiconductor layer and an n-type impurity doped layer portion at a gate electrode side.

8. A field effect transistor claimed in Claim 5 wherein said semiconductor barrier layer is formed of a material selected from the group consisting of (Al_{X}Ga1-X)_{Y}In_{1-Y}P where 0.2≤X≤0.3, and 0.4<Y≤1.0 and (Al_{X}Ga_{1-X})_{Y}In_{1-Y}As where 0.4≤X≤1, and 0.6≤Y<0.7, and said semiconductor barrier layer having an undoped layer portion at a side of said first semiconductor layer and an n-type impurity doped layer portion at a gate electrode side.

9. A field effect transistor claimed in Claim 6 wherein said semiconductor barrier layer is formed of a material selected from the group consisting of (Al_{X}Ga_{1-X})_{Y}In_{1-Y}P where 0.2≤X≤0.3, and 0.4<Y≤1.0 and (Al_{X}Ga_{1-X})_{Y}In_{1-Y}As where 0.4≤X≤1, and 0.6≤Y<0.7, and said semiconductor barrier layer having an undoped layer portion at a side of said first semiconductor layer and an n-type impurity doped layer portion at a gate electrode side.

10. A field effect transistor claimed in Claim 1 further including an n-type impurity doped semiconductor layer formed under said first semiconductor layer and having an electron affinity smaller that of said first semiconductor layer.

11. A field effect transistor which includes at least a first semiconductor layer in which carriers flows, and a second semiconductor layer formed on said first semiconductor layer, said second semiconductor layer having an electron affinity smaller that of said first semiconductor layer, and said second semiconductor layer being doped with an n-type impurity, wherein a first semiconductor barrier layer is inserted between said first semiconductor layer and said second semiconductor layer, and a second semiconductor barrier layer is inserted between said second semiconductor layer and a gate electrode, each of said first and second semiconductor barrier layers having a positive electron energy at a conduction band bottom of a Γ valley, in comparison with an electron energy at a conduction band bottom of a Γ valley in said second semiconductor layer, each of said first and second semiconductor barrier layers having a film thickness of not less than 3nm but not greater than 10nm.

12. A field effect transistor claimed in Claim 11 wherein at least one of said first and second semiconductor barrier layers is in lattice mismatching with a semiconductor substrate on which semiconductor layers are grown, and a maximum film thickness of said at least one of said first and second semiconductor barrier layers in which no dislocation occurs, is less than 10nm, said at least one of said first and second semiconductor barrier layers having the film thickness of not less than 3nm but not greater than the maximum film thickness in which no dislocation occurs.

13. A field effect transistor claimed in Claim 11 wherein said first semiconductor layer is formed of a material selected from the group consisting of InGaAs and GaAs, said second semiconductor layer is formed of a material selected from the group consisting of Al_{X₁}Ga_{1-X₁}As where 0≤X₁≤0.3, and InGaP, and wherein said first semiconductor barrier layer is formed of a material selected from the group consisting of Al_{X₂}Ga_{1-X₂}As where 0.4<X₂≤1, (Al_{X₃}Ga_{1-X₃})_{Y₁}In_{1-Y₁}P where 0.2≤X₃≤1, and 0.4<Y₁<0.6, and (Al_{X₄}Ga_{1-X₄})_{Y₂}In_{1-Y₂}P where 0≤X₄≤1, and 0.6≤Y₂≤1, and said second semiconductor barrier layer is formed of a material selected from the group consisting of Al_{X₅}Ga_{1-X₅}As where 0.4<X₅≤1, (Al_{X₆}Ga_{1-X₆})_{Y₃}In_{1-Y₃}P where 0.2≤X₆≤1, and 0.4<Y₃<0.6, and (Al_{X₇}Ga_{1-X₇})_{Y₄}In_{1-Y₄}P where 0≤X₇≤1 and 0.6<Y₄≤1.

14. A field effect transistor claimed in Claim 11 wherein said first semiconductor layer is formed of InGaAs, said second semiconductor layer is formed of a material selected from the group consisting of AlInAs and AlGaInAs, and wherein said first semiconductor barrier layer is formed of (Al_{X₁}Ga_{1-X₁})_{Y₁}In_{1-Y₁}As where 0.4≤X₁≤1, and 0.6≤Y₁≤1, and said second semiconductor barrier layer is formed of (Al_{X₂}Ga_{1-X₂})_{Y₂}In_{1-Y₂}As where 0.4≤X₂≤1, and 0.6≤Y₂≤1.

15. A field effect transistor claimed in Claim 13 wherein said first semiconductor barrier layer near to said first semiconductor layer is formed of a material selected from the group consisting of (Al_{X}Ga₁₋ _{X})_{Y}In_{1-Y}P where 0.2≤X≤0.3, and 0.4<Y≤1.0 and (Al_{X}Ga_{1-X})_{y}In_{1-Y}As where 0.4≤X≤1, and 0.6≤Y<0.7, and a portion or all of said first semiconductor barrier layer is doped with an n-type impurity.

16. A field effect transistor claimed in Claim 14 wherein said first semiconductor barrier layer near to said first semiconductor layer is formed of a material selected from the group consisting of (AlₓGa₁₋ _{X})_{Y}In_{1-Y}P where 0.2≤X≤0.3, and 0.4<Y≤1.0 and (Al_{X}Ga_{1-X})_{Y}In_{1-Y}As where 0.4≤X≤1, and 0.6≤Y<0.7, and a portion or all of said first semiconductor barrier layer is doped with an n-type impurity.

17. A field effect transistor claimed in Claim 11 further including an n-type impurity doped semiconductor layer formed under said first semiconductor layer and having an electron affinity smaller that of said first semiconductor layer.
